# EUROPÄISCHE PATENTSCHRIFT

(11) **EP 4 176 277 B1**
(45) Veröffentlichungstag und Bekanntmachung des Hinweises auf die Patenterteilung: **04.12.2024**
(21) Anmeldenummer: 21742072.8
(22) Anmeldetag: 02.07.2021
(51) Int. Cl.: G01R 31/62

(54) **VORRICHTUNG ZUR ERMITTLUNG EINES FEHLERWAHRSCHEINLICHKEITSWERTS FÜR EINE TRANSFORMATORKOMPONENTE SOWIE EIN SYSTEM MIT EINER DERARTIGEN VORRICHTUNG**
DEVICE FOR DETERMINING AN ERROR PROBABILITY VALUE FOR A TRANSFORMER COMPONENT AND A SYSTEM HAVING SUCH A DEVICE
DISPOSITIF DE DÉTERMINATION D'UNE VALEUR DE PROBABILITÉ D'ERREUR POUR UN COMPOSANT DE TRANSFORMATEUR, ET SYSTÈME COMPORTANT UN TEL DISPOSITIF

(30) Priorität: 04.08.2020 DE 102020120539
(43) Veröffentlichungstag der Anmeldung: 10.05.2023
(73) Patentinhaber: Maschinenfabrik Reinhausen GmbH, 93059 Regensburg (DE)
(72) Erfinder: ALBER, Alexander, 93047 Regensburg (DE)
(86) Internationale Anmeldenummer: PCT/EP2021/068331
(87) Internationale Veröffentlichungsnummer: WO 2022/028789

(56) Entgegenhaltungen:
- EP-A1- 3 514 908
- CN-A- 102 779 230
- CN-A- 104 007 343
- CN-A- 111 272 222
- DE-B4- 102018 206 326
- JP-A- 2007 328 522
- US-A1- 2014 222 355
- US-A1- 2016 274 551
- US-A1- 2019 165 988

## Beschreibung

Transformatoren sind grundsätzlich aus dem Stand der Technik bekannt. Hierbei handelt es sich um Transformatoren, die eine elektrische Eingangsspannung in eine elektrische Ausgangsspannung umwandeln können. Für gewöhnlich ist die Eingangsspannung eine Eingangswechselspannung und die Ausgangsspannung eine Ausgangswechselspannung. In einer sehr einfachen Ausgestaltung weist der Transformator eine Primärspule und eine Sekundärspule auf, die über einen gemeinsamen Kern miteinander gekoppelt sind. Die Spulen und/oder der Kern können zumindest teilweise in einem Tank mit Kühlflüssigkeit angeordnet sein, um die Spulen zu kühlen. Die Primärspule, die Sekundärspule, der Kern, die Kühlflüssigkeit und der Tank können jeweils eine Transformatorkomponente des Transformators sein. Der Transformator kann noch weitere Transformatorkomponenten aufweisen.

In der Praxis werden Transformatoren oftmals mittels eines Messsystems überwacht. Das Messsystem weist mehrere Sensoren auf, die zur Erfassung von physischen und/oder chemischen Eigenschaften des Transformators ausgebildet sind. Ein Messsystem wird oftmals dann eingesetzt, wenn der Transformator als ein sogenannter Leistungstransformator ausgebildet ist. Dies ist beispielsweise dann der Fall, wenn die übertragene, elektrische Leistung von Primär- zu Sekundärspule größer als 10 Kilowatt ist. Die beiden Spulen eines Leistungstransformators erzeugen im aktiven Betrieb eine nicht unerhebliche Wärme, die von der Kühlflüssigkeit des Leistungstransformators zumindest teilweise aufgenommen wird. Die Kühlflüssigkeit kann in einem Kühlflüssigkeitskreislauf des Leistungstransformators gefördert sein, wobei in dem Kühlflüssigkeitskreislauf ein sogenannter Kühler integriert ist, der die an die Kühlflüssigkeit übertragene Wärme an die Umgebung und/oder an ein anderes Medium übertragen kann. Das Messsystem kann deshalb beispielsweise einen Sensor aufweisen, der zur Erfassung der Temperatur der Kühlflüssigkeit des Leistungstransformators ausgebildet ist. An dem Kühler kann ein Ventilator angeordnet sein, um eine gewünschte Kühlleistung zu erreichen. Der durch einen Ventilatormotor des Ventilators fließende, elektrische Strom kann beispielsweise mittels eines weiteren Sensors des Messsystems erfasst werden. Als Kühlflüssigkeit wird oftmals ein Öl, das auch als Isolieröl bezeichnet sein kann, verwendet. Durch die isolierende Eigenschaft des Öls wird ein elektrischer Kurzschluss innerhalb der Spulen oder zwischen den Spulen verhindert. Das Messsystem kann einen weiteren Sensor aufweisen, der zur direkten oder indirekten Erfassung eines Wasseranteils in dem Öl ausgebildet ist. So kann der Sensor beispielsweise in direktem Kontakt mit dem Öl sein, um den Wasseranteil direkt zu erfassen. Es besteht jedoch auch die Möglichkeit, dass ein Sensor in dem Tank des Leistungstransformators angeordnet ist, wobei dieser Sensor zur Erfassung einer Gas-Konzentration mit Kohlenwasserstoffketten ausgebildet ist. Eine von dem Sensor erfasste Gas-Konzentration mit Kohlenwasserstoffketten, die größer als ein vorbestimmter Schwellwert ist, kann auf einen bestimmten Mindestwasseranteil in dem Öl hinweisen. Ein weiterer Sensor des Messsystems kann beispielsweise zur Erfassung einer mechanischen Wicklungsspannungskraft zwischen den Windungen einer der Spulen ausgebildet sein. Dieser Sensor kann beispielsweise als ein Sensor zur Erfassung eines mechanischen Drucks oder einer mechanischen Kraft ausgebildet sein, wobei der Sensor derart an der Primär- oder Sekundärspule des Leistungstransformators angeordnet ist, um die mechanische Spannkraft der jeweiligen Spule zu erfassen. Ein weiterer Sensor des Messystems kann zur Erfassung des Stroms durch die Primär- oder Sekundärspule angeordnet und/oder ausgebildet sein. Darüber hinaus kann das Messsystem einen Spannungssensor aufweisen, der zur Erfassung einer elektrischen Spannung der an der Primär- oder Sekundärspule anliegenden elektrischen Spannung ausgebildet ist. Ein weiterer Sensor des Messsystems kann beispielsweise zur Erfassung des Zustands der Transformatordurchführungen ausgebildet sein, wobei der Sensor beispielsweise dazu ausgebildet ist Kapazität und/oder Verlustfaktor der Transformatordurchführungen zu bestimmen. Ein weiterer Sensor des Messsystems kann beispielsweise zur Erfassung vibroakustischer Signale ausgebildet sein. Dieser Sensor kann beispielsweise als ein Sensor zur Erfassung akustischer Signale ausgeprägt sein, die bei der Betätigung eines Stufenschalters des Leistungstransformators entstehen. Das Messsystem kann zur Erzeugung eines Statussignals ausgebildet sein, das mehrere unterschiedliche Statusgrößen repräsentiert. Das Messsystem kann ausgebildet sein, mindestens eine der Statusgröße jeweils basierend auf dem Sensorsignal genau einer der Sensoren und/oder eine der Statusgröße jeweils basierend auf mehreren Sensorsignal von mehreren Sensoren zu ermitteln. Jeder der Sensoren ist an dem Leistungstransformator angeordnet, um eine physischen und/oder chemischen Eigenschaft des Leistungstransformators zu erfassen. Die physischen und/oder chemischen Eigenschaften können somit entsprechend physische und/oder chemische Eigenschaften von Komponenten des Leistungstransformators sein. Die Komponenten des Leistungstransformators werden auch als Transformatorkomponenten bezeichnet. Die Kühlflüssigkeit des Transformators kann beispielsweise eine Komponente des Leistungstransformators sein. Aber auch die Spannung oder der Strom an der ersten bzw. zweiten Spule des Leistungstransformators können jeweils eine physische Eigenschaft des Leistungstransformators sein. Jede von dem Messsystem ermittelte Statusgröße repräsentiert einen Statuszustand der von dem mindestens einen zugeordneten Sensor erfassten Eigenschaft des Leistungstransformators als Normalzustand N oder als Anormalzustand. Wird beispielsweise eine Statusgröße basierend auf dem Sensorsignal des Sensors zur Erfassung der Temperatur der Kühlflüssigkeit ermittelt, so kann für die Transformatorkomponente "Kühlflüssigkeit" ein Normalzustand von dem Messsystem bestimmt werden, und zwar insbesondere dann, wenn die mittels des Sensors erfasste Temperatur der Kühlflüssigkeit kleiner als ein Referenzwert ist. Anderenfalls kann von dem Messsystem für den Statuszustand ein Anormalzustand bestimmt werden. Zwischen jeder Statusgröße und jeweils mindestens einer der Transformatorkomponenten, deren Eigenschaft direkt oder indirekt mittels des mindestens einen zugehörigen Sensors erfasst wird, besteht deshalb eine funktionale Beziehung. Es wird deshalb auch davon gesprochen, dass jede Statusgröße über eine funktionale Beziehung mit mindestens einer der Transformatorkomponenten gekoppelt ist.

Die von dem Messsystem ermittelten Statusgrößen können Statuszustände des Leistungstransformators repräsentieren, und zwar jeweils als Normalzustand oder als Anormalzustand. Bezieht sich eine Statusgröße auf eine einzelne Transformatorkomponente, so kann in diesem Fall der Statuszustand unmittelbar Aufschluss darüber geben, ob die jeweilige Transformatorkomponente in einem Normalzustand oder in einem Anormalzustand ist. Wird eine Statusgröße hingegen basierend auf mehreren Sensorsignalen von mehreren Sensoren ermittelt, besteht oftmals keine direkte, eindeutige Beziehung zwischen dem von der jeweiligen Statusgröße repräsentierten Statuszustand und einer einzigen Transformatorkomponente. Vielmehr kann eine funktionale Beziehung zwischen dem genannten Statuszustand und mehreren Transformatorkomponenten bestehen. Darüber hinaus kann eine Transformatorkomponente Einfluss auf mehrere Sensorsignale haben. Eine in einem Anormalzustand befindliche Transformatorkomponente kann dadurch dazu führen, dass von dem Messsystem mehrere Statusgrößen derart bestimmt werden, dass die Statusgrößen jeweils ein Statuszustand als ein Anormalzustand repräsentieren.

Wenn mehrere Statusgrößen als Statuszustand einen Anormalzustand repräsentieren, ist es in der Praxis nicht immer trivial und eindeutig ermittelbar, ob und welche der Transformatorkomponenten in einem Anormalzustand sind oder ob nur eine einzige in einem Anormalzustand befindliche Transformatorkomponente ursächlich dafür ist, dass gleich mehrere Statusgrößen als Statuszustand einen Anormalzustand repräsentieren.

In diesem Zusammenhang beschreibt CN 111 272 222 A ein Verfahren zur Diagnose von Transformatorfehlern auf Grundlage eines Kenngrößensatzes.

CN 104 007 343 B zeigt ein Verfahren zur dynamischen Fehlerdiagnose für einen Transformator basierend auf einem Bayesschen Netz.

CN 102 779 230 B offenbart ein Verfahren zur Zustandsanalyse sowie zur Erstellung von Wartungsempfehlungen von Leistungstransformatoren unter Nutzung eines Markov-Models.

JP 2007 328522 A beschreibt ein Verfahren zur Ermittlung der Ausfallwahrscheinlichkeit einer Vorrichtung anhand von Fehlerprotokollen, die nach der Inbetriebnahme der Vorrichtung ermittelt werden.

US 2014/222355 A1 bezieht sich auf die Vorhersage und Diagnose von Zuständen von Energieübertragungs- und -verteilungsanlagen, wie Transformatoren und insbesondere auf einen statistischen Ansatz zur Diagnose, Erkennung und Erkennung von Anlagenfehlern sowie zur Gesamtgesundheit von Anlagen.

Der Erfindung liegt deshalb die Aufgabe zugrunde, eine Vorrichtung und ein System vorzuschlagen, die eine besonders einfache Auswertung erlaubt, ob und welche Transformatorkomponente eines Leistungstransformators fehlerhaft ist bzw. sind. Gemäß einem ersten Aspekt der Erfindung wird die Aufgabe gelöst durch eine Vorrichtung mit den Merkmalen des Anspruchs 1. Vorgesehen ist also eine Vorrichtung zur Ermittlung eines Fehlerwahrscheinlichkeitswerts für eine Transformatorkomponente. Die Vorrichtung weist eine Signaleingangsschnittstelle, eine Prozessoreinheit, und eine Speichereinheit auf. Die Signaleingangsschnittstelle ist zur direkten oder indirekten Kopplung mit einem Messsystem für einen Leistungstransformator ausgebildet, wobei das Messsystem mehrere Sensoren aufweist, die jeweils zur Erfassung einer physischen und/oder chemischen Eigenschaft des Leistungstransformators ausgebildet sind, wobei der Leistungstransformator mehrere Transformatorkomponenten aufweist, und wobei jeder Sensor mit mindestens einer der Transformatorkomponenten des Leistungstransformators über eine jeweils zugehörige direkte oder indirekte Verbindung gekoppelt ist, so dass die von dem jeweiligen Sensor erfasste Eigenschaft des Leistungstransformators von mindestens einer der Transformatorkomponenten beeinflusst ist. Darüber hinaus ist die Signaleingangsschnittstelle zum Empfang eines Statussignals des Messystems ausgebildet, wobei das Statussignal mehrere, unterschiedliche Statusgrößen repräsentiert, wobei jeder Statusgröße mindestens einer der Sensoren zugeordnet ist, so dass jede Statusgröße in einer funktionalen Beziehung mit mindestens einer der Transformatorkomponenten ist, wobei jede Statusgröße einen Statuszustand der von dem mindestens einen zugeordneten Sensor erfassten Eigenschaft des Leistungstransformators als Normalzustand oder als Anormalzustand repräsentiert. Außerdem ist ein Datensatz von der Speichereinheit gespeichert, wobei der Datensatz zu jeder Statusgröße einen zugehörigen, ersten Wahrscheinlichkeitswert aufweist, dass die jeweilige Statusgröße einen falschen Zustand repräsentiert, wobei der Datensatz zu jeder Transformatorkomponente einen zugehörigen, zweiten Wahrscheinlichkeitswert aufweist, dass in der jeweiligen Transformatorkomponente ein Fehler aufgetreten ist, wobei der Datensatz zu jeder der funktionalen Beziehungen von einer der Transformatorkomponenten zu einem der Statusgrößen einen zugehörigen, dritten Wahrscheinlichkeitswert aufweist, dass ein Fehler in der jeweiligen Transformatorkomponente einen Anormalzustand der jeweiligen Statusgröße verursacht. Die Prozessoreinheit ist konfiguriert, für jede Transformatorkomponente einen zugehörigen Fehlerwahrscheinlichkeitswert basierend auf einem Bayesschen Netz, das einen gerichteten Graphen von den Transformatorkomponenten zu den Statusgrößen basierend auf den ersten, zweiten und dritten Wahrscheinlichkeitswerten repräsentiert, sowie basierend auf den von den Statusgrößen repräsentierten Statuszuständen zu ermitteln, dass die jeweilige Transformatorkomponente in einem Fehlerzustand ist.

In Bezug auf den Leistungstransformator und das Messsystem wird vorzugsweise auf die eingangs genannten Erläuterungen in analoger Weise Bezug genommen. Das Messsystem und der Leistungstransformator sind vorzugsweise keine Teile der Vorrichtung. Vielmehr ist es bevorzugt vorgesehen, dass die Signaleingangsschnittstelle zum Empfang des Statussignals des Messsystems ausgebildet ist. Das Statussignal repräsentiert mehrere, unterschiedliche Statusgrößen, die jeweils einen Statuszustand der von dem mindestens einen zugeordneten Sensor des Messsystems erfassten Eigenschaft des Leistungstransformators als Normalzustand oder als Anormalzustand repräsentiert. Vorzugsweise ist der Statuszustand entweder der Normalzustand oder der Anormalzustand. Über das empfangbare Statussignal werden in der Vorrichtung also mehrere, unterschiedliche Statusgrößen zur Verfügung gestellt, die als Statuszustand jeweils einen Anormalzustand oder einen Normalzustand für eine entsprechende Eigenschaft des Leistungstransformators repräsentieren. Aus den Statusgrößen lässt sich jedoch nur mit viel Erfahrung ablesen, welche der Transformatorkomponenten tatsächlich fehlerhaft sein könnten. Um eine wiederholbare und quantifizierbare Aussage in Bezug auf einen möglichen Fehler einer Transformatorkomponente zu erhalten, weist die Vorrichtung eine Prozessoreinheit und eine Speichereinheit auf.

Die Speichereinheit speichert einen Datensatz, der zu jeder Statusgröße einen zugehörigen, ersten Wahrscheinlichkeitswert umfasst. Dieser erste Wahrscheinlichkeitswert gibt eine Wahrscheinlichkeit für die jeweilige Statusgröße vorzugsweise unabhängig von dem jeweils tatsächlichen Statuszustand, der von der Statusgröße repräsentiert wird, an, dass der von der jeweiligen Statusgröße repräsentierte Zustand, also Normalzustand oder Anormalzustand, als ein falscher Zustand ist. Wird von einer Statusgröße beispielsweise ein Normalzustand als Statuszustand repräsentiert, so besteht eine gewisse Wahrscheinlichkeit, nämlich korrespondierend zu dem ersten Wahrscheinlichkeitswert, dass der von der Statusgröße repräsentierte Statuszustand tatsächlich nicht ein Normalzustand ist, sondern ein Anormalzustand sein müsste. Ist der erste Wahrscheinlichkeitswert beispielsweise 0,05, so besteht eine fünfprozentige Wahrscheinlichkeit, dass der von der jeweiligen Statusgröße repräsentierte Statuszustand falsch ist.

Der von der Speichereinheit gespeicherte Datensatz umfasst außerdem zu jeder Transformatorkomponente des Leistungstransformators einen zugehörigen, zweiten Wahrscheinlichkeitswert. Der zweite Wahrscheinlichkeitswert gibt eine Wahrscheinlichkeit an, dass in der jeweiligen Transformatorkomponente ein Fehler aufgetreten sein könnte. Durch statistische Erhebungen an Transformatoren und/oder praktischen Erfahrungen kann beispielsweise festgestellt werden, dass es Transformatorkomponenten gibt, die öfter ausfallen als andere Transformatorkomponenten eines Leistungstransformators. Aus der statistischen Erhebung und/oder der Erfahrung lässt sich deshalb ableiten, wie die statistischen Wahrscheinlichkeiten für Fehler der Transformatorkomponenten sind. Basierend auf diesen statistischen Wahrscheinlichkeiten der Transformatorkomponenten können deshalb die zweiten Wahrscheinlichkeitswerte vorbestimmt sein. So kann beispielsweise für die Primärspule eines Leistungstransformators ein zugehöriger, zweiter Wahrscheinlichkeitswert vorbestimmt sein, der eine Wahrscheinlichkeit angibt, dass die Primärspule des Leistungstransformators einen Fehler aufweist. In entsprechender Weise kann für eine vorbestimmte Anzahl der Transformatorkomponente eines Leistungstransformators ein zugehöriger, zweiter Wahrscheinlichkeitswert vorbestimmt sein.

Der von der Speichereinheit gespeicherte Datensatz umfasst außerdem zu jeder der funktionalen Beziehungen von einer der Transformatorkomponenten zu einer der Statusgrößen einen zugehörigen, dritten Wahrscheinlichkeitswert. Der jeweilige dritte Wahrscheinlichkeitswert gibt deshalb eine Wahrscheinlichkeit an, dass ein Fehler in der jeweiligen Transformatorkomponente einen Anormalzustand in der jeweils in funktionaler Beziehung stehenden Statusgröße verursacht. Ist eine Statusgröße genau einem Sensor zugeordnet, der eine physische und/oder chemische Eigenschaft von genau einer Transformatorkomponente erfassen kann, so kann die dritte Wahrscheinlichkeit repräsentieren, ob ein Fehler in dieser Transformatorkomponente zu einem Anormalzustand der durch den Sensor bedingten Statusgröße führt. Es besteht jedoch auch die Möglichkeit, dass eine Transformatorkomponente eine direkte oder indirekte Beziehung zu mehreren Sensoren aufweist, sodass ein Fehler in der jeweiligen Transformatorkomponente gleich mehrere Statusgrößen beeinflussen kann. Ob dies statistisch gesehen für die mehreren Sensoren und entsprechenden Statusgrößen eintritt, wird durch die zugehörigen dritten Wahrscheinlichkeitswerte repräsentiert.

Aus den vorangegangenen Erläuterungen ist zumindest indirekt zu entnehmen, dass die Sensoren und somit auch die Statusgrößen nicht immer einen direkten Rückschluss auf einen Zustand von genau einer Transformatorkomponente zulässt, die möglicherweise einen Fehler aufweist. Vielmehr ist es zumeist so, dass wenn eine oder mehrere der Statusgrößen als Statuszustand einen Anormalzustand repräsentieren, dass gleich mehrere Transformatorkomponenten in Frage kommen, die fehlerhaft sein können. Funktional besteht deshalb eine gerichtete Beziehung von den Transformatorkomponenten zu den Sensoren und somit auch zu den Statusgrößen, jedoch keine eindeutige Beziehung von den Statusgrößen zu den Transformatorkomponenten. Um dennoch eine Aussage ableiten zu können, welche und ob eine der Transformatorkomponenten fehlerhaft ist, ist die Prozessoreinheit der Vorrichtung konfiguriert, für jede Transformatorkomponente einen zugehörigen Fehlerwahrscheinlichkeitswert basierend auf einem Bayesschen Netz sowie basierend auf den von den Statusgrößen repräsentierten Statuszuständen zu ermitteln, ob die jeweilige Transformatorkomponente in einem Fehlerzustand ist. Jeder Fehlerwahrscheinlichkeitswert gibt vorzugsweise eine Wahrscheinlichkeit (Fehlerwahrscheinlichkeit) für die jeweilige Transformatorkomponenten an, dass die jeweilige Transformatorkomponente in einem Fehlerzustand ist. Der Fehlerzustand kann als ein Anormalzustand der Transformatorkomponente verstanden werden. Wird für eine Transformatorkomponente beispielsweise ein Fehlerwahrscheinlichkeitswert von 0,001 ermittelt, so besteht eine Wahrscheinlichkeit von 0,1%, dass die jeweilige Transformatorkomponente fehlerhaft ist. Dies ist verhältnismäßig klein und deutet eher darauf hin, dass die jeweilige Transformatorkomponente nicht fehlerhaft ist. Wird für eine andere Transformatorkomponente hingegen ein zugehöriger Fehlerwahrscheinlichkeitswert von 0,7 mittels der Prozessoreinheit ermittelt, so deutet dies darauf hin, dass die jeweilige Transformatorkomponente mit einer Wahrscheinlichkeit von 70 % fehlerhaft ist. Die Ermittlung der Fehlerwahrscheinlichkeitswerte basierend auf dem Bayesschen Netz und den Statusgrößen, die der Vorrichtung von dem Messsystem über das Statussignal zur Verfügung gestellt werden. Bayessche Netze sind grundsätzlich aus dem Stand der Technik bekannt. Es bedarf an dieser Stelle deshalb keiner weiteren und tiefgehenderen Erläuterung. Bei dem Bayesschen Netz bilden die Transformatorkomponenten eine erste Gruppe von Knoten und die Statusgröße eine zweite Gruppe von Knoten, wobei ausschließlich gerichtete, funktionale Beziehungen von jeder Transformatorkomponente zu mindestens einem der Statusgrößen bestehen.

Die Prozessoreinheit kann konfiguriert sein, die Fehlerwahrscheinlichkeitswerte durch Auswertung des Bayesschen Netzes und unter Berücksichtigung der tatsächlichen Statuszustände auszuführen, und zwar beispielsweise mittels einem der folgenden Algorithmen: Sampling Algorithmus oder Variable Elimination Algorithmus. Beide Algorithmen sind grundsätzlich aus dem Stand der Technik bekannt. Andere Algorithmen können ebenfalls verwendet werden. Die Prozessoreinheit kann ausgebildet sein, jeden der beiden Algorithmen oder andere Algorithmen auszuführen. Es kann jedoch auch ausreichen, wenn die Prozessoreinheit konfiguriert ist, einen der beiden genannten Algorithmen aufzuführen, um die Fehlerwahrscheinlichkeitswerte zu ermitteln.

Das Bayessche Netz, das zur Ermittlung der Fehlerwahrscheinlichkeitswerte verwendet wird, wird durch einen gerichteten Graphen von den Transformatorkomponenten zu den Statusgrößen repräsentiert. Der Datensatz weist für jede der Transformatorkomponenten jeweils einen ersten Wahrscheinlichkeitswert, für jede der Statusgröße jeweils einen zweiten Wahrscheinlichkeitswert und für jede der gerichteten Beziehungen von Transformatorkomponente zu Zustandsgröße jeweils einen dritten Wahrscheinlichkeitswert auf. Indem das Bayessche Netz den Graphen als gerichteten Graphen von den Transformatorkomponenten zu den Zustandsgrößen repräsentiert, entspricht dies einer Abbildung der realen statistischen Verhältnisse in Bezug auf den Leistungstransformator und das Messsystem. Basierend auf dem Bayesschen Netz ist es jedoch möglich unter Berücksichtigung der tatsächlichen Statusgrößen zu ermitteln, welche Fehlerwahrscheinlichkeitswerte und zugehörige Fehlerwahrscheinlichkeiten für die Transformatorkomponenten bestehen, dass die jeweilige Transformatorkomponente in einem Fehlerzustand bzw. in einem Anormalzustand ist.

Die Vorrichtung bietet deshalb den Vorteil, dass trotz der gerichteten, funktionalen Beziehung zwischen den Transformatorkomponenten und den Statusgrößen auf quantitative Fehlerwahrscheinlichkeitswerte für die Transformatorkomponenten geschlossen werden kann, die eine Aussage darüber erlauben, welche der Transformatorkomponenten beispielsweise die höchste Wahrscheinlichkeit eines Fehlers hat.

Eine vorteilhafte Ausgestaltung der Vorrichtung zeichnet sich dadurch aus, dass die Prozessoreinheit konfiguriert ist, basierend auf dem Bayesschen Netz, das einen gerichteten Graphen von den Transformatorkomponenten zu den Statusgrößen basierend auf den ersten, zweiten und dritten Wahrscheinlichkeitswerten repräsentiert, eine Vielzahl von Mustern zu erzeugen, wobei jedes Muster für jede Statusgröße und für jede Transformatorkomponente einen jeweils zugehörigen Musterzustand als Normalzustand oder Anormalzustand repräsentiert. Die Prozessoreinheit ist konfiguriert, aus der Vielzahl der Muster eine Referenzgruppe von Mustern zu bestimmen, so dass bei jedem Muster der Referenzgruppe die zugehörigen Musterzustände für die Statusgrößen mit den Statuszuständen der Statusgrößen des Statussignals übereinstimmen. Die Prozessoreinheit ist außerdem konfiguriert, für jede Transformatorkomponente einen zugehörigen Fehlerwahrscheinlichkeitswert basierend auf den Musterzuständen für die Transformatorkomponenten aus den Mustern der Referenzgruppe zu ermitteln, dass die jeweilige Transformatorkomponente in einem Anormalzustand ist.

Die zuvor genannte Ausgestaltung der Vorrichtung basiert auf dem Grundgedanken, dass zunächst eine Vielzahl von Muster erzeugt werden, und dass anschließend basierend auf den tatsächlichen Statuszuständen der Statusgrößen bestimmt wird, welche der zuvor erzeugten Muster einer Referenzgruppe zugeordnet werden. Die Muster aus der Referenzgruppe weisen also jeweils für die Statusgrößen Musterzustände auf, die den tatsächlichen Statuszuständen entsprechen, die von den Statusgrößen des Statussignal repräsentiert sind, das die Vorrichtung von dem Messsystem empfängt. Mit anderen Worten werden auf den tatsächlichen Statuszuständen mittels der Prozessoreinheit bestimmt, welche der Muster für die entsprechenden Statusgrößen Musterzustände aufweisen, die den tatsächlichen Statuszuständen entsprechen. Die derart bestimmten Muster bilden die Muster der Referenzgruppe. Bei der Bestimmung der Muster für die Referenzgruppe wird jedoch nicht auf die Musterzustände für die Transformatorkomponenten geachtet. Vielmehr dienen diese in einem weiteren Schritt zur Bestimmung der Fehlerwahrscheinlichkeitswerte der Transformatorkomponenten.

Wie bereits zuvor erläutert worden ist, kann aus den Statuszuständen zumeist nicht direkt auf die Zustände der Transformatorkomponenten geschlossen werden. Jedes Muster aus der Referenzgruppe weist aber auch für jede Transformatorkomponente einen zugehörigen Musterzustand auf. Aufgrund der Vielzahl der Muster in der Referenzgruppe ergibt sich daraus für jede Transformatorkomponente eine entsprechende Vielzahl von Musterzuständen, aus deren Verteilung eine Wahrscheinlichkeit ableitbar, dass die jeweilige Transformatorkomponente in einem Anormalzustand ist. Die Prozessoreinheit kann deshalb für jede Transformatorkomponente basierend auf den Mustern der Referenzgruppe einen zu der jeweiligen zu der Transformatorkomponente zugehörigen Fehlerwahrscheinlichkeitswert ermitteln, der die Wahrscheinlichkeit repräsentiert, dass die jeweilige Transformatorkomponente in einem Anormalzustand ist.

Die Prozessoreinheit ist ausgebildet, die Vielzahl der Muster zu erzeugen, wobei jedes Muster für jede Statusgröße und für jede Transformatorkomponente einen jeweils zugehörigen Musterzustand als Normalzustand oder Anormalzustand repräsentiert. Der von der Speichereinheit gespeicherte Datensatz umfasst zu jeder Statusgröße einen zugehörigen, ersten Wahrscheinlichkeitswert. Durch die Erzeugung der Vielzahl der Muster wird beispielsweise für jede Statusgröße eine entsprechende Vielzahl von Musterzuständen erzeugt. Diese Erzeugung der Musterzustände erfolgt jedoch nicht beliebig, sondern unter Berücksichtigung des ersten Fehlerwahrscheinlichkeitswerts, sodass die Musterzustände für die Statusgrößen mit einer Wahrscheinlichkeit entsprechend dem ersten Wahrscheinlichkeitswert als Anormalzustand erzeugt werden. Ist der erste Wahrscheinlichkeitswert beispielsweise 0,2, so werden die Vielzahl der Musterzustände für die zugehörige Statusgröße derart erzeugt, dass 20% der Musterzustände einen Anormalzustand repräsentieren, und die übrigen 80 % der Musterzustände einen Normalzustand repräsentieren. Die Erzeugung der Vielzahl der Musterzustände für die übrigen Statusgrößen erfolgt in analoger Weise. Entsprechendes gilt im Übrigen auch für die Musterzustände für die Transformatorkomponenten. Denn für jede Transformatorkomponente ist von dem Datensatz ein zugehöriger, zweiter Wahrscheinlichkeitswert repräsentiert. Jedes Muster repräsentiert für jede Transformatorkomponente einen zugehörigen Musterzustand als Normalzustand oder als Anormalzustand. Diese Erzeugung der Musterzustände für die Transformatorkomponenten erfolgt jedoch nicht beliebig, sondern unter Berücksichtigung des zweiten Fehlerwahrscheinlichkeitswerts, sodass die Musterzustände für die Transformatorkomponenten mit einer Wahrscheinlichkeit entsprechend dem zweiten Wahrscheinlichkeitswert als Anormalzustand erzeugt werden. Ist der zweite Wahrscheinlichkeitswert beispielsweise 0,15, so werden die Vielzahl der Muster von der Prozessoreinheit derart erzeugt, dass 15% der Musterzustände für die jeweilige Transformatorkomponente einen Anormalzustand repräsentieren und die übrigen 85% der Musterzustände einen Normalzustand repräsentieren. Darüber hinaus ist anzumerken, dass die Vielzahl der Muster unter Berücksichtigung der Fehlerwahrscheinlichkeitswerte zufällig erzeugt werden. Die Prozessoreinheit ist hierzu entsprechend ausgebildet. Umso größer die Vielzahl der Muster ist, umso genauer kann für jede Transformatorkomponente ein zugehöriger Fehlerwahrscheinlichkeitswert ermittelt werden, der jeweils die Wahrscheinlichkeit angibt, ob die jeweilige Transformatorkomponente in einem Anormalzustand ist.

Eine weitere vorteilhafte Ausgestaltung der Vorrichtung zeichnet sich dadurch aus, dass die Vorrichtung eine Ausgangsschnittstelle aufweist, wobei die Vorrichtung ausgebildet ist, ein Ausgangssignal zu erzeugen, das zumindest den größten der Fehlerwahrscheinlichkeitswerte und die zugehörige Transformatorkomponente repräsentiert, und wobei die Vorrichtung ausgebildet ist, das Ausgangssignal mittels der Signalausgangsschnittstelle zu übertragen.

In der vorangegangenen Ausgestaltung wurde erläutert, dass für jede Transformatorkomponente ein zugehöriger Fehlerwahrscheinlichkeitswert ermittelt wird. Sind eine Mehrzahl von Transformatorkomponenten vorhanden, wird auch eine entsprechende Anzahl von Fehlerwahrscheinlichkeitswerten ermittelt. Diese Fehlerwahrscheinlichkeitswerte können sich unterscheiden. Am relevantesten ist jedoch die größte Fehlerwahrscheinlichkeitswert, denn dieser gibt an, welche der Transformatorkomponenten am Wahrscheinlichsten in einem Anormalzustand ist. Die Prozessoreinheit ist also vorzugsweise dazu konfiguriert, aus der Mehrzahl der Fehlerwahrscheinlichkeitswerte den größten Fehlerwahrscheinlichkeitswert und die zugehörige Transformatorkomponente zu bestimmen. Außerdem ist die Vorrichtung, und insbesondere die zugehörige Prozessoreinheit, ausgebildet, ein Ausgangssignal zu erzeugen, das den größten Fehlerwahrscheinlichkeitswert repräsentiert, und die zugehörige Transformatorkomponente indiziert. So kann das Ausgangssignal beispielsweise eine Transformatorkomponente mit den Ziffern "01" und den zugehörigen Fehlerwahrscheinlichkeitswert als "0,7" repräsentieren. Es ist jedoch auch möglich, dass das Ausgangssignal die jeweilige Transformatorkomponente im Klartext repräsentiert. So kann das Ausgangssignal beispielsweise die Transformatorkomponente "Kühlflüssigkeit" und den zugehörigen Fehlerwahrscheinlichkeitswert mit "0,7" repräsentieren. Mittels der Signalausgangsschnittstelle der Vorrichtung kann das Ausgangssignal übertragen werden. Die Vorrichtung kann hierzu entsprechend ausgebildet sein. Das Ausgangssignal kann beispielsweise an eine Anzeigeeinheit übertragen werden, um den vom Ausgangssignal repräsentierten Fehlerwahrscheinlichkeitswert in Zusammenhang mit der Transformatorkomponente optisch darzustellen.

Eine weitere vorteilhafte Ausgestaltung der Vorrichtung zeichnet sich dadurch aus, dass die Vorrichtung ausgebildet ist, das Ausgangssignal derart zu erzeugen, dass das Ausgangssignal zumindest die zwei oder drei größten Fehlerwahrscheinlichkeitswerte und die zugehörigen Transformatorkomponenten repräsentiert. In der Praxis ist oftmals die Transformatorkomponente mit dem größten Fehlerwahrscheinlichkeitswert am interessantesten. Der entsprechende Fehlerwahrscheinlichkeitswert repräsentiert jedoch weiterhin eine Wahrscheinlichkeit, sodass die zugehörige Transformatorkomponente nicht zwingend fehlerhaft sein muss. In der Praxis können deshalb auch die Transformatorkomponenten interessant sein, zu denen ebenfalls große Fehlerwahrscheinlichkeitswerte ermittelt worden sind. Die Prozessoreinheit der Vorrichtung kann deshalb dazu konfiguriert sein, die zwei oder drei größten Fehlerwahrscheinlichkeitswerte zu bestimmen. Außerdem kann die Vorrichtung, und insbesondere die zugehörige Prozessoreinheit, dazu ausgebildet sein, das Ausgangssignal derart zu erzeugen, dass das Ausgangssignal die zuvor bestimmten, zwei oder drei größten Fehlerwahrscheinlichkeitswerte repräsentiert und die zugehörigen Transformatorkomponenten zumindest indiziert. Die vorangegangenen Erläuterungen zu dem größten Fehlerwahrscheinlichkeitswert und dem Ausgangssignal gelten in analoger Weise für die zwei oder drei größten Fehlerwahrscheinlichkeitswerte und die zugehörigen Transformatorkomponenten. Mit dem Ausgangssignal, das jedoch die zwei oder drei größten Fehlerwahrscheinlichkeitswerte und die zugehörigen Transformatorkomponenten repräsentiert, erhält der Fachmann darüber hinaus die Information, welche Transformatorkomponenten ebenfalls fehlerhaft sein können, insbesondere dann, wenn die Transformatorkomponente, für die der größte Fehlerwahrscheinlichkeitswert bestimmt wurde, tatsächlich nicht fehlerhaft ist. Der Fachmann kann somit seine Untersuchung fortsetzen, und beispielsweise auch die Transformatorkomponente untersuchen, für die der zweitgrößte Fehlerwahrscheinlichkeitswert ermittelt wurde.

Eine weitere vorteilhafte Ausgestaltung der Vorrichtung zeichnet sich dadurch aus, dass die vom Statussignal repräsentierten Statusgrößen ternäre Statusgrößen sind, die jeweils genau einen Statuszustand aus der folgenden Gruppe der möglichen Statuszustände repräsentieren: Normalzustand, Anormalzustand oder Nichtinstallationszustand. Damit wird ausgeschlossen, dass der Statuszustand etwas anderes repräsentieren kann als den Normalzustand, den Anormalzustand oder den Nichtinstallationszustand. Es kann alternativ auch vorgesehen sein, dass die Gruppe der möglichen Zustände auf zwei Zustände beschränkt ist, nämlich Normalzustand und Anormalzustand. In diesem Fall kann der Statuszustand entweder den Normalzustand oder den Anormalzustand repräsentieren, jedoch keinen anderen Zustand.

Eine weitere vorteilhafte Ausgestaltung der Vorrichtung zeichnet sich dadurch aus, dass die Prozessoreinheit konfiguriert ist, dass Bayessche Netz basierend auf dem Datensatz zu erzeugen. Das Bayessche Netz ist vorzugsweise ein gerichteter, azyklischer Graph, in dem jedem Knoten des Graphens Wahrscheinlichkeitswerte zugeordnet sind, und die Abhängigkeiten von den Knoten ebenfalls durch Wahrscheinlichkeitswerte repräsentiert sind. In dem vorliegenden Fall repräsentiert das Bayessche Netz eine erste Gruppe von Knoten aus Statusgrößen, denen jeweils ein zugehöriger, erster Wahrscheinlichkeitswert zugeordnet ist. Die zweite Gruppe von Knoten des Bayesschen Netzes ist durch die Transformatorkomponenten des Leistungstransformators repräsentiert, wobei jedem dieser Knoten jeweils ein zugehöriger, zweiter Wahrscheinlichkeitswert zugeordnet ist. Die Abhängigkeit der Statusgrößen von den Transformatorkomponenten wird jeweils durch entsprechende dritte Wahrscheinlichkeitswerte repräsentiert. Die ersten, zweiten und dritten Wahrscheinlichkeitswerte sind in dem Datensatz vorhanden, wobei der Datensatz in der Speichereinheit der Vorrichtung gespeichert ist. Die Prozessoreinheit kann deshalb, insbesondere basierend auf den vorangegangenen Erläuterungen, das Bayessche Netz basierend auf den Wahrscheinlichkeitswerten aus dem Datensatz erzeugen.

Eine weitere Ausgestaltung der Vorrichtung zeichnet sich dadurch aus, dass das Bayessche Netz als ein bipartiter Graph ausgebildet ist, der eine erste Gruppe von Knoten, eine zweite Gruppe von Knoten und funktionale Beziehungen von der ersten Gruppe von Knoten zur zweiten Gruppe von Knoten repräsentiert, wobei die erste Gruppe von Knoten durch die ersten Wahrscheinlichkeitswerte, die zweite Gruppe von Knoten durch die zweiten Wahrscheinlichkeitswerte und die funktionalen Beziehungen durch die dritten Wahrscheinlichkeitswerte bestimmt sind. Das Bayessche Netz wird also gemäß dieser Ausgestaltungsvariante als ein spezielles Bayessches Netz in Form eines bipartiten Graphen verwendet. Das gewährleistet, dass ausschließlich funktionale Beziehungen von den Transformatorkomponenten zu den Statusgrößen gehen, jedoch dass es keine umgekehrte, abhängige Beziehung gibt. Mit anderen Worten ist der bipartite Graph derart ausgebildet, dass die Statusgrößen nur von den Eigenschaften der Transformatorkomponenten abhängen, jedoch dass die Eigenschaften der Transformatorkomponenten nicht von den Zuständen der Statusgrößen abhängen. Andere Beziehungen als die zuvor genannten Beziehungen sind vorzugsweise ausgeschlossen. Dadurch lassen sich alle Beziehungen zwischen den Transformatorkomponenten und den Statusgrößen als zweidimensionale Tabelle darstellen, deren Einträge vorzugsweise durch Expertenwissen bestimmt und leicht konfigurierbar ist.

Eine weitere vorteilhafte Ausgestaltung der Vorrichtung zeichnet sich dadurch aus, dass die Prozessoreinheit konfiguriert ist, die Muster mittels eines Wahrscheinlichkeitsgewichtungsalgorithmus (likelihood weighting algorithm) zu erzeugen. Hierbei werden von der Prozessoreinheit vorzugsweise die ersten, zweiten und dritten Wahrscheinlichkeitswerte des Datensatzes berücksichtigt.

Eine weitere vorteilhafte Ausgestaltung der Vorrichtung zeichnet sich dadurch aus, dass die Prozessoreinheit ausgebildet ist, das Ausgangssignal derart zu erzeugen, so dass das Ausgangssignal die zugehörige Fehlerwahrscheinlichkeitswerte und Transformatorkomponenten als ein erstes Bild repräsentiert, in dem die Fehlerwahrscheinlichkeitswerte graphisch dargestellt und die Transformatorkomponenten indiziert und/oder bezeichnet sind. Ein solches Bild kann beispielsweise die Fehlerwahrscheinlichkeitswerte als Balkengraph darstellen, wobei zu jedem Balkengraph die jeweils zugehörige Transformatorkomponente indiziert und/oder bezeichnet ist. Die jeweilige Transformatorkomponente kann beispielsweise durch eine Ziffer indiziert oder als Text, wie beispielsweise "Kühlflüssigkeit" bezeichnet sein. Die Wahrscheinlichkeitswerte können quantitativ und/oder qualitativ in dem Bild graphisch dargestellt sein. Eine qualitative Darstellung eines Wahrscheinlichkeitswerts kann beispielsweise durch den Farbton und/oder durch eine Länge eines Balkens repräsentiert sein. Eine quantitative Darstellung eines Wahrscheinlichkeitswerts kann beispielsweise die zahlenmäßige graphische Darstellung des Wahrscheinlichkeitswerts sein. Die Vorrichtung kann das Ausgangssignal beispielsweise dazu verwenden, um ein entsprechendes Bild mittels einer Anzeigeeinheit der Vorrichtung anzuzeigen. Es kann jedoch auch vorgesehen sein, dass das Ausgangssignal über die Ausgangsschnittstelle übertragen wird. Hierzu kann die Prozessoreinheit und insbesondere die zugehörige Ausgangsschnittstelle ausgebildet und/oder konfiguriert sein.

Gemäß einem zweiten Aspekt der Erfindung wird die eingangs genannte Aufgabe gelöst durch ein System mit den Merkmalen des Anspruchs 10. Vorgesehen ist also ein System, das eine Vorrichtung und eine Anzeigeeinheit aufweist. Die Vorrichtung ist vorzugsweise gemäß dem ersten Aspekt der Erfindung und/oder einer der zugehörigen, vorteilhaften Ausgestaltungen ausgebildet. Die Anzeigeeinheit weist einen Bildschirm auf. Die Signalschnittstelle der Vorrichtung ist über eine direkte oder indirekte, erste Signalverbindung mit der Anzeigeeinheit gekoppelt, um das Ausgangssignal an die Anzeigeeinheit zu übertragen. Die Anzeigeeinheit ist außerdem ausgebildet, ein die Transformatorkomponenten und zugehörigen Fehlerwahrscheinlichkeitswerte indizierendes, zweites Bild auf dem Bildschirm basierend auf dem Ausgangssignal anzuzeigen. Das zuvor genannte, zweite Bild setzt nicht voraus, dass es bereits ein erstes Bild geben muss. Darüber hinaus wird auf die vorteilhaften Ausgestaltungen, bevorzugten Merkmale, Effekte und/oder Vorteile, wie sie im Zusammenhang mit der Vorrichtung gemäß dem ersten Aspekt und/oder einer der vorteilhaften, zugehörigen Ausgestaltungen erläutert worden sind, in analoger Weise für das System gemäß dem zweiten Aspekt der Erfindung Bezug genommen.

Das System umfasst die Vorrichtung und die Anzeigeeinheit mit dem Bildschirm. Auf dem Bildschirm kann das zweite Bild angezeigt werden, das den mindestens einen Fehlerwahrscheinlichkeitswert, der von dem Ausgangssignal repräsentiert ist, und die zugehörigen Transformatorkomponenten graphisch darstellt. Diese Darstellung kann eine qualitative und/oder quantitative Darstellung des mindestens einen Fehlerwahrscheinlichkeitswerts und eine quantitative und/oder qualitative Darstellung der mindestens einen, zugehörigen Transformatorkomponente umfassen. Wird von dem Ausgangssignal beispielsweise der größte Fehlerwahrscheinlichkeitswert sowie die zugehörige Transformatorkomponente repräsentiert, kann das zweite Bild in entsprechender Weise den größten Fehlerwahrscheinlichkeitswert und die zugehörige Transformatorkomponente graphisch darstellen. Die Anzeigeeinheit kann physisch getrennt von der Vorrichtung ausgebildet sein, sodass die erste Signalverbindung sich auch zwischen der Vorrichtung und der Anzeigeeinheit erstreckt. Die erste Signalverbindung kann eine leitungsgebundene Signalverbindung oder eine Funk-Signalverbindung sein. Grundsätzlich ist es jedoch auch möglich, dass die Anzeigeeinheit einen integralen Teil der Vorrichtung bildet, sodass das System aus der Vorrichtung mit der integrierten Anzeigeeinheit besteht. Das System kann auch noch weitere Teile aufweisen.

Eine weitere vorteilhafte Ausgestaltung des Systems zeichnet sich dadurch aus, dass die Anzeigeeinheit ausgebildet ist, so dass das zweite Bild die von dem Ausgangssignal repräsentierten Transformatorkomponenten listenförmig und die zugehörigen Fehlerwahrscheinlichkeitswerte durch unterschiedliche Farben und/oder Balken qualitativ anzeigt. Die Fehlerwahrscheinlichkeitswerte können ergänzend auch quantitativ von der Anzeigeeinheit angezeigt werden. Außerdem ist es bevorzugt vorgesehen, dass die Anzeigeeinheit ausgebildet ist, die Fehlerwahrscheinlichkeitswerte in einer Reihenfolge gemäß der Größe der Fehlerwahrscheinlichkeitswerte listenförmig anzuzeigen. Dadurch erhält ein Betrachter in kürzester Zeit einen Überblick darüber, welche der Transformatorkomponenten möglicherweise in einem Anormalzustand sind, und welche von diesen möglichen Transformatorkomponenten die höchste Wahrscheinlichkeit aufweisen, dass der entsprechende Anormalzustand vorliegt.

Eine weitere vorteilhafte Ausgestaltung des Systems zeichnet sich dadurch aus, dass das System ein Messsystem für den Leistungstransformator aufweist, wobei das Messsystem mit der Signaleingangsschnittstelle der Vorrichtung gekoppelt ist, um das Statussignal an die Signaleingangsschnittstelle zu übertragen, wobei das Messystem mehrere Sensoren aufweist, die jeweils zur Erfassung der physischen und/oder chemischen Eigenschaft des Leistungstransformators ausgebildet sind. Der Leistungstransformator weist mehrere Transformatorkomponenten auf. Jeder Sensor ist mit mindestens einer der Transformatorkomponenten des Leistungstransformators über eine jeweils zugehörige direkte oder indirekte Verbindung gekoppelt, so dass die von dem jeweiligen Sensor erfasste Eigenschaft des Leistungstransformators von mindestens einer der Transformatorkomponenten beeinflusst ist. In Bezug auf das Messsystem, die Sensoren und den Leistungstransformator wird auf die eingangs genannten Erläuterungen in analoger Weise Bezug genommen. So kann das Messsystem mehrere Sensoren aufweisen, wobei jeder Sensor dazu ausgebildet ist, eine physische und/oder chemische Eigenschaft des Leistungstransformators zu erfassen. Nicht immer ist es dabei möglich, auch die Eigenschaft einer gewünschten Transformatorkomponente direkt zu erfassen. Oftmals wird eine Eigenschaft des Leistungstransformators mittels eines Sensors erfasst, wobei diese Eigenschaft nur indirekt von dem Zustand einer Transformatorkomponente abhängt. Das Messsystem kann in unmittelbarer Nähe zu dem Leistungstransformator angeordnet sein, wobei die Sensoren des Messsystems direkt an dem Leistungstransformator befestigt sind, um die entsprechenden, physischen und/oder chemischen Eigenschaften des Leistungstransformators erfassen zu können. Jeder der Sensoren kann mit einer Auswerteeinheit des Messsystems gekoppelt sein, sodass das Messsystem mittels der Auswerteeinheit ausgebildet ist, um das Statussignal zu erzeugen. Die Auswerteeinheit des Messsystems kann auch dazu ausgebildet sein, um das Statussignal an die Signaleingangsschnittstelle der Vorrichtung zu übertragen. Grundsätzlich ist es bevorzugt, wenn das Messystem und die Vorrichtung getrennt ausgebildet sind. Es ist jedoch auch möglich, dass das Messsystem und die Vorrichtung zumindest teilweise oder vollständig integral ausgebildet sind. So kann die Vorrichtung beispielsweise einen Teil des Messystems, oder umgekehrt, bilden.

Eine weitere vorteilhafte Ausgestaltung des Systems zeichnet sich dadurch aus, dass das Messsystem ausgebildet ist, mindestens zwei der folgenden Eigenschaften des Leistungstransformators sensorisch zu erfassen: Gas aus Kohlenwasserstoffketten im flüssigen Isoliermedium, Wasser im flüssigen Isoliermedium, Füllstand des flüssigen Isoliermedium, elektrische Spannung, elektrischer Strom, Wicklungsspannkraft, Drehgeschwindigkeit eines Ventilators, elektrische Leistung des Ventilatormotors, Lautstärke des Ventilators, Motordrehmoment eines Stufenschalters, Schaltsequenz des Stufenschalters, Temperatur (z.B. Hot-Spot-Temperatur oder Top-Oil-Temperatur), Vibroakustische Intensität, und Funktionsfähigkeit des Luftentfeuchters, Verlustfaktor von einer oder mehreren Transformatordurchführungen, Kapazität von einer oder mehreren Transformatordurchführungen, Vibroakustische Intensität des Stufenschalters. Der Leistungstransformator umfasst vorzugsweise einen Tank, der mit Kühlflüssigkeit gefüllt ist. Die Kühlflüssigkeit wird auch als Isolierflüssigkeit oder als Isoliermedium bezeichnet, denn vorzugsweise ist die Kühlflüssigkeit elektrisch isolierend ausgebildet. Die Kühlflüssigkeit kann vorzugsweise ein Öl, insbesondere ein Mineralöl sein. Oftmals ist die Kühlflüssigkeit ein Ester aus Rapsöl. Die Kühlflüssigkeit, die auch als Isolierflüssigkeit bezeichnet werden kann, ist also beispielsweise Öl, vorzugsweise basierend auf einem Ester, und besonders bevorzugt ist es ein flüssiges Isoliermedium wie Rapsöl. Die Kühlflüssigkeit hat vorzugsweise zwei Hauptaufgaben. Die Kühlflüssigkeit soll die Primär- und Sekundärspulen kühlen, und die Kühlflüssigkeit soll elektrisch isolierend sein. In dem zuvor genannten Tank befindet sich vorzugsweise auch der Trafokern und die Primär- und Sekundärspulen. In dem Tank wird deshalb zumeist die größte Wärme des Transformators frei. Mittels der Kühlflüssigkeit wird die an den Spulen verursachte Wärme abgeführt. Der Transformator kann somit ein Leitungssystem und einen Kühler aufweisen, die derart ausgebildet und angeordnet sind, um Kühlflüssigkeit aus dem Tank durch das Leitungssystem zu dem Kühler und wieder zurück zum Tank zu führen, sodass die Wärme über den Kühler abgeführt werden kann. Der Leistungstransformator ist vorzugsweise zum Verbinden von unterschiedlichen, elektrischen Netzen mit unterschiedlicher elektrischer Spannung ausgebildet. So kann der Leistungstransformator beispielsweise ein erstes Netz mit einer niedrigeren Spannung mit einem zweiten Netz mit einer höheren Spannung, oder umgekehrt, elektrisch koppeln, um elektrische Energie von dem einen Netz zu dem anderen Netz zu übertragen. Die elektrischen Netze sind vorzugsweise jeweils dreiphasig. In jedem Netz kann somit an drei Phasen jeweils ein zugehöriger Strom und eine zugehörige Spannung auftreten. Die entsprechenden Ströme und/oder Spannungen können sensorisch erfasst werden. Hierzu kann das Messsystem Sensoren aufweisen, die entsprechend ausgebildet und/oder angeordnet sind. Theoretisch können alle Ströme und Spannungen der beiden Netze durch Sensoren erfasst werden. Praktisch erfolgt meistens nur die Erfassung eines Teils der Ströme und Spannungen in den beiden Netzen. Das Messsystem kann deshalb dazu ausgebildet sein, einen Teil der elektrischen Spannungen und Ströme in den beiden Netzen, mit dem der elektrische Leistungstransformator koppelbar ist, zu erfassen.

Eine weitere vorteilhafte Ausgestaltung des Systems zeichnet sich dadurch aus, dass die Anzeigeeinheit einen Teil des Messsystems bildet. Das Messsystem ist oftmals in unmittelbarer Nähe zum Leistungstransformator angeordnet. Die Vorrichtung kann physisch getrennt von dem Messsystem und dem Leistungstransformator angeordnet sein. Insbesondere kann es vorgesehen sein, dass die Vorrichtung durch ein Computernetzwerk, insbesondere ein Cloud-Netzwerk, gebildet ist, das einen Datenspeicher umfasst. Somit ist es möglich, dass die Vorrichtung eine Prozessoreinheit mit einer besonders hohen Rechenleistung bietet. Das Anzeigen des zweiten Bilds auf der Anzeigevorrichtung ist insbesondere dann von Vorteil, wenn die Anzeigevorrichtung Teil des Messsystems und somit in unmittelbarer Nähe zum Leistungstransformator ist. Denn vielfach werden diese Informationen bei der Wartung und/oder Reparatur eines Leistungstransformators benötigt.

Eine weitere vorteilhafte Ausgestaltung des Systems zeichnet sich dadurch aus, dass das System ein Fernüberwachungssystem aufweist, wobei die Signalausgangsschnittstelle der Vorrichtung über eine direkte oder indirekte, zweite Signalverbindung mit dem Fernüberwachungssystem gekoppelt ist, um das Ausgangssignal an das Fernüberwachungssystem zu übertragen. Das Fernüberwachungssystem ist örtlich von der Vorrichtung, dem Messsystem und dem Leistungstransformator getrennt angeordnet. Das Fernüberwachungssystem kann beispielsweise von einer Leitstelle gebildet sein, in der eine Vielzahl von Leistungstransformatoren überwacht werden.

Eine weitere vorteilhafte Ausgestaltung des Systems zeichnet sich dadurch aus, dass das Fernüberwachungssystem Cloud-basiert ausgebildet ist. Das Fernüberwachungssystem kann somit von einem Cloud-Netzwerk mit einer Vielzahl von Computereinheiten gebildet sein.

Eine weitere vorteilhafte Ausgestaltung des Systems zeichnet sich dadurch aus, dass die Anzeigevorrichtung des Systems einen Teil des Fernüberwachungssystems bildet. Die Anzeigevorrichtung kann somit getrennt von der Vorrichtung, dem Messsystem und dem Leistungstransformator angeordnet sein.

Eine weitere vorteilhafte Ausgestaltung des Systems zeichnet sich dadurch aus, dass das System den Leistungstransformator umfasst. Das System kann somit den Leistungstransformator, das Messsystem und die Vorrichtung umfassen. Außerdem kann es vorgesehen sein, dass das System zusätzlich noch das Fernüberwachungssystem umfasst.

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen. In den Figuren stehen weiterhin gleiche Bezugszeichen für gleiche oder ähnliche Objekte.
- Figur 1: zeigt eine vorteilhafte Ausgestaltung der Vorrichtung und des Systems jeweils in einer schematischen Darstellung.
- Figur 2: zeigt eine vorteilhafte Ausgestaltung des Bayesschen Netzes in einer schematischen Darstellung.
- Figur 3: zeigt eine beispielhafte, tabellarische Darstellung von Mustern.
- Figur 4: zeigt eine beispielhafte, tabellarische Darstellung von Mustern einer Referenzgruppe.
- Figur 5: zeigt eine beispielhafte Darstellung eines Bildes, das auf einer Anzeigeeinheit wiedergegeben werden kann.

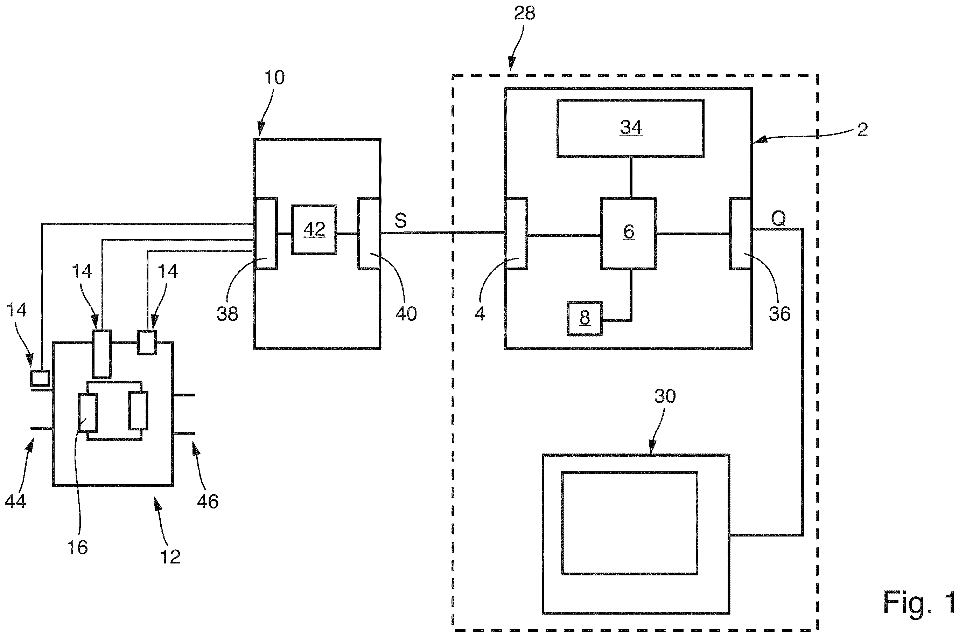

In der Figur 1 ist eine vorteilhafte Ausgestaltung der Vorrichtung 2 schematisch dargestellt. Die Vorrichtung 2 weist eine Prozessoreinheit 6, eine Signaleingangsschnittstelle 4 und eine Speichereinheit 8 auf. Die Prozessoreinheit 6 ist derart mit der Speichereinheit 8 verbunden, sodass die Prozessoreinheit 6 auf Daten zugreifen kann, die in der Speichereinheit 8 gespeichert sind. Somit kann die Prozessoreinheit 6 beispielsweise auf einen Datensatz zugreifen, der in der Speichereinheit 8 gespeichert ist. Außerdem ist die Prozessoreinheit 6 mit der Signaleingangsschnittstelle 4 verbunden, sodass ein Signal, das von der Signaleingangsschnittstelle 4 empfangen wird, der Prozessoreinheit 6 direkt oder indirekt zur Verfügung gestellt wird. Die Signaleingangsschnittstelle 4 kann beispielsweise eine Datenvorverarbeitung ausführen, um die von dem empfangenen Signal repräsentierten Daten für die Prozessoreinheit 6 zur Verfügung zu stellen. Als vorteilhaft hat es sich herausgestellt, wenn die Vorrichtung 2 eine Signalausgangsschnittstelle 36 aufweist. Ein von der Vorrichtung 2, und insbesondere von der Prozessoreinheit 6, erzeugtes Signal, wie beispielsweise ein Ausgangssignal Q, kann mittels der Signalausgangsschnittstelle 36 versendet werden. Die Prozessoreinheit 6 kann dazu direkt oder indirekt mit der Signalausgangsschnittstelle 36 gekoppelt sein, um die Signalausgangsschnittstelle 36 direkt oder indirekt zu steuern, sodass mittels der Signalausgangsschnittstelle 36 das Ausgangssignal Q versendet werden kann.

In der Figur 1 ist außerdem eine vorteilhafte Ausgestaltung des Systems 28 dargestellt, das die Vorrichtung 2 und eine Anzeigeeinheit 30 umfasst. Das System 28 ist durch eine gestrichelte Linie schematisch dargestellt, um aufzuzeigen, dass die Anzeigeeinheit 30 nicht notwendigerweise Teil der Vorrichtung 2 sein muss. Die Vorrichtung 2 kann eine dedizierte Anzeigeeinheit 34 aufweisen. Die Vorrichtung 2 und die Anzeigeeinheit 30 können über eine zwischen der Vorrichtung 2 und der Anzeigeeinheit 30 verlaufenden Signalverbindung gekoppelt sein, die auch als erste Signalverbindung bezeichnet wird. Die erste Signalverbindung kann sich von der Signalausgangsschnittstelle 36 der Vorrichtung 2 zu der Anzeigeeinheit 30 erstrecken. Die Anzeigeeinheit 30 weist einen Bildschirm auf.

Wenn im Folgenden vorteilhafte Ausgestaltungen, bevorzugte Merkmale, technische Effekte und/oder Vorteile der Vorrichtung 2 erläutert werden, so können entsprechende, vorteilhafte Ausgestaltungen, bevorzugten Merkmale, technische Effekte und/oder Vorteile in analoger Weise für das System 28 gelten. Auf eine Wiederholung wird deshalb verzichtet.

In der Figur 1 sind neben der Vorrichtung 2 auch ein Messsystem 10 und ein Leistungstransformator 12 schematisch dargestellt. Der Leistungstransformator 12 weist Anschlüsse 44 auf der Primärseite und weitere Anschlüsse 46 auf der Sekundärseite auf. Der Leistungstransformator 12 dient zur Transformation einer Spannung von der Primärseite zu der Sekundärseite. An der Primärseite und der Sekundärseite können unterschiedliche, elektrische Netze angekoppelt sein, sodass elektrische Energie von der Primärseite an die Sekundärseite, oder umgekehrt, übertragen werden kann.

Der Leistungstransformator 12 weist eine Vielzahl von Transformatorkomponenten 16 auf. So kann der Leistungstransformator 12 als Transformatorkomponenten 16 beispielsweise die Anschlüsse 44, 46, eine Primärspule, eine Sekundärspule, einen Kern, einen Tank für Kühlflüssigkeit, die Kühlflüssigkeit, ein Kühlsystem, einen Kühler, einen Ventilator zum Kühlen des Kühlers, einen Stufenschalter, einen Motor zum Antrieb des Stufenschalters, Durchführungen, Ventile, Feststoffisolation zur Wicklungsisolierung und/oder andere technische Bauteile aufweisen.

Das Messsystem 10 umfasst mehrere Sensoren 14. Jede der Sensoren 14 ist an dem Leistungstransformator 12 angeordnet, sodass jeder Sensor 14 eine physische und/oder chemische Eigenschaft des Leistungstransformators 12 erfassen kann. So kann ein Sensor 14 beispielsweise derart angeordnet sein, um eine Temperatur der Kühlflüssigkeit des Leistungstransformators 12 zu erfassen. Ein weiterer Sensor 14 kann beispielsweise zur Erfassung einer mechanischen Spannkraft zwischen den Wicklungen der Primär- und Sekundärspule ausgebildet und/oder entsprechend angeordnet sein. Die Spannkraft wird auch als Wicklungsspannkraft bezeichnet. Somit kann der jeweilige Sensor 14 zur Erfassung der Wicklungsspannkraft ausgebildet sein. Ein weiterer Sensor 14 kann derart angeordnet sein, um beispielsweise die elektrische Spannung zwischen den Anschlüssen 44 an der Primärseite zu erfassen. Ein weiterer Sensor 14 des Messsystems 10 kann beispielsweise zur Erfassung des Zustands der Transformatordurchführungen ausgebildet sein, wobei der Sensor beispielsweise dazu ausgebildet ist Kapazität und/oder Verlustfaktor der Transformatordurchführungen zu bestimmen. Ein weiterer Sensor 14 des Messsystems 10 kann beispielsweise zur Erfassung vibroakustischer Signale ausgebildet sein. Dieser Sensor 14 kann beispielsweise als ein Sensor zur Erfassung akustischer Signale ausgeprägt sein, die bei der Betätigung eines Stufenschalters des Leistungstransformators 12 entstehen. Die in Figur 1 gezeigten Sensoren sind nur beispielhafte Sensoren 14. Tatsächlich können noch viele weitere Sensoren 14 und/oder andere Sensoren 14 für das Messsystem 10 vorgesehen sein.

Die Sensoren 14 können zur Erfassung von Kräften, mechanischen Spannungen, elektrischen Strömen, elektrischen Spannungen, Temperaturen, Drücken, Massenströmen und/oder akustischem Schall ausgebildet sein.

Jede der Transformatorkomponenten 16 kann unterschiedliche Eigenschaften, insbesondere unterschiedliche physische und/oder chemische Eigenschaften aufweisen. In der Praxis wurde festgestellt, dass nicht sämtliche Eigenschaften einer Transformatorkomponente 16 notwendigerweise mit einem Sensor 14 erfasst werden können. Die Temperatur in einer Primärspule oder einer Sekundärspule kann beispielsweise oftmals nur indirekt über die Temperatur der Kühlflüssigkeit erfasst werden. Es besteht somit grundsätzlich ein funktionaler Zusammenhang zwischen der Temperatur der Primärspule bzw. Sekundärspule und der von einem Sensor 14 erfassten Temperatur der Kühlflüssigkeit. Aus der erfassten Temperatur der Kühlflüssigkeit kann jedoch nicht direkt darauf geschlossen werden, ob und welche Temperatur eine der beiden Spulen aufweist. Insbesondere kann bei einer überhöhten Temperatur der Kühlflüssigkeit nicht eindeutig bestimmt werden, welche der beiden Spulen beispielsweise in einem fehlerhaften Zustand ist, sodass die jeweils fehlerhafte Spule zu viel Wärme an die Kühlflüssigkeit abgibt und die zuvor genannte, überhöhte Temperatur der Kühlflüssigkeit verursacht.

Das zuvor genannte Beispiel macht deutlich, dass die von den Sensoren 14 erfassten, physischen und/oder chemischen Eigenschaften des Leistungstransformators 12 zwar ein Indiz geben können, dass eine der Transformatorkomponenten 16 in einem nicht normalen, also einem anormalen, Zustand ist. Dieser nicht normale bzw. anormale Zustand wird auch als Anormalzustand der jeweiligen Transformatorkomponente 16 bezeichnet. Es besteht deshalb der Bedarf, dass eine Vorrichtung 2 bereitgestellt wird, die ausgebildet ist, um basierend auf der Vielzahl der von den Sensoren 14 erfassten, physischen und/oder chemischen Eigenschaften eine besonders Abschätzung ermitteln kann, ob und welche Transformatorkomponente(n) 16 fehlerhaft sind, wenn auffällige Eigenschaften des Leistungstransformator 12 sensorisch erfasst werden.

Das zuvor erläuterte Problem wird mit der Vorrichtung 2 gelöst, wie sie beispielhaft und schematisch in der Figur 1 dargestellt ist. Die Vorrichtung 2 weist die zuvor genannte Signaleingangsschnittstelle 4 auf, die zur direkten oder indirekten Kopplung mit einem Messsystem 10 ausgebildet ist. Das Messsystem 10 weist mehrere Sensoren 14 auf, die jeweils zur Erfassung einer physischen und/oder chemischen Eigenschaft des Leistungstransformators 12 ausgebildet sind. Der Leistungstransformator 12 weist mehrere Transformatorkomponenten 16 auf. Jeder der Sensoren 14 des Messsystems 10 ist mit mindestens einer der Transformatorkomponenten 16 des Leistungstransformators 12 über eine jeweilige zugehörige, direkte oder indirekte Verbindung gekoppelt. Hierbei handelt es sich vorzugsweise um eine funktionale Verbindung. Durch die direkte oder indirekte Verbindung zwischen den Sensoren 14 und den Transformatorkomponenten 16 kann der technische Effekt erreicht werden, dass die von dem jeweiligen Sensor 14 erfasste Eigenschaft des Leistungstransformators 12 von mindestens einer der Transformatorkomponenten 16 beeinflusst ist.

Das Messsystem 10 kann eine Eingangsschnittstelle 38, eine Ausgangsschnittstelle 40 und eine Auswerteeinheit 42 aufweisen. Die Sensoren 14 sind vorzugsweise mit der Eingangsschnittstelle 38 gekoppelt, so dass die von den Sensoren 14 erfassten Eigenschaften, vorzugsweise über ein Sensorsignal, an die Auswerteeinheit 42 übertragen werden. Die Auswerteeinheit 42 kann dazu ausgebildet sein, um die von den Sensoren 14 erfassten Eigenschaften auszuwerten und ein Statussignal S zu erzeugen, das mehrere, unterschiedliche Statusgrößen repräsentiert. Jede Statusgröße kann beispielsweise angeben, ob einer der Sensoren 14 eine chemische und/oder physische Eigenschaft des Leistungstransformators 12 erfasst hat, die größer als ein zugehöriger Grenzwert oder kleiner als ein entsprechender Grenzwert ist. Das Statussignal S repräsentiert unterschiedliche Statusgrößen, wobei jeder Statusgröße mindestens einer der Sensoren 14 zugeordnet ist, sodass jede Statusgröße über eine funktionale Beziehung mit mindestens einer der Transformatorkomponenten 16 gekoppelt ist. Hierbei handelt es sich nicht um eine mechanische Kopplung, sondern um eine funktionale Kopplung im Sinne einer funktionalen Beziehung. Jede Statusgröße repräsentiert einen Statuszustand der von dem mindestens einen zugeordneten Sensor 14 erfassten Eigenschaft des Leistungstransformators 12 als Normalzustand N oder als Anormalzustand A. Der Statuszustand kann also entweder der Normalzustand N oder der Anormalzustand A sein, wobei der jeweilige Statuszustand von der Statusgröße repräsentiert ist. Ist eine Eigenschaft des Transformators beispielsweise die Temperatur der Kühlflüssigkeit, so kann der Statuszustand der Temperatur der Kühlflüssigkeit in dem Normalzustand sein, wenn die Temperatur unterhalb von einer vorbestimmten Maximaltemperatur ist, und in einem Anormalzustand sein, wenn die Temperatur die Maximaltemperatur erreicht oder noch größer ist.

Das Statussignal S repräsentiert mehrere der unterschiedlichen Statusgrößen. Außerdem ist die Signaleingangsschnittstelle 4 der Vorrichtung 2 zum Empfang des Statussignals S des Messsystems 10 ausgebildet. Nachdem das Messsystem 10 die Eigenschaften des Leistungstransformators 12 mittels der Sensoren 14 erfasst hat, kann das Messsystem 10 also das Statussignal S von einer zugehörigen Ausgangsschnittstelle 40 des Messsystems 10 an die Signaleingangsschnittstelle 4 der Vorrichtung 2 übertragen.

Die Prozessoreinheit 6 der Vorrichtung 2 ist vorzugsweise mit der Signaleingangsschnittstelle 4 gekoppelt, sodass die von dem Statussignal S repräsentierten Statusgrößen der Prozessoreinheit 6 zur Verfügung gestellt werden. Die Prozessoreinheit 6 der Vorrichtung 2 ist konfiguriert, für jede Transformatorkomponente 16 einen zugehörigen Fehlerwahrscheinlichkeitswert basierend auf einem Bayesschen Netz 18 sowie basierend auf den Statuszuständen, die von dem Statusgrößen des Statussignal repräsentiert sind, zu ermitteln, wobei der jeweilige Fehlerwahrscheinlichkeitswert eine Wahrscheinlichkeit angibt, dass die jeweilige Transformatorkomponente 16 in einem Fehlerzustand ist. Der Fehlerzustand kann ein Anormalzustand der jeweiligen Transformatorkomponente 16 sein.

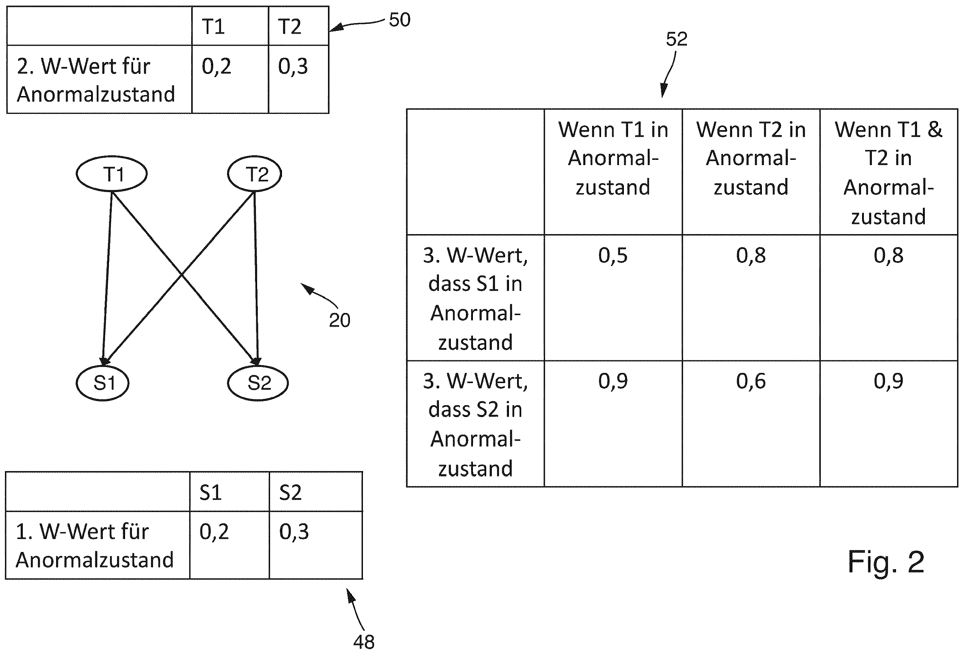

In der Figur 2 ist ein Beispiel eines derartigen Bayesschen Netzes 18 dargestellt, das als ein gerichteter Graphen 20 von den Transformatorkomponenten 16, die in diesem Fall als erste Transformatorkomponente T1 und zweite Transformatorkomponente T2 bezeichnet sind, zu den Statusgrößen S1, S2 ausgestaltet ist. Der gerichtete Graph 20 basiert auf den ersten Wahrscheinlichkeitswerten, den zweiten Wahrscheinlichkeitswerten und den dritten Wahrscheinlichkeitswerten. Der Graph 20 ist ein gerichteter, azyklischer und bipartiter Graph, sodass es nur Beziehungen von den Transformatorkomponenten T1, T2 zu den Statusgrößen S1, S2 gibt. Die Statusgrößen S1, S2 hängen also von den Zuständen der Transformatorkomponenten T1, T2 ab. Jedoch hängen die Zustände der Transformatorkomponenten T1, T2 nicht von den Zuständen der Statusgrößen S1, S2 ab. Darüber hinaus gibt es keine Beziehungen zwischen den Statusgrößen S1, S2. Auch ist es bevorzugt vorgesehen, dass der Graph 20 keine Beziehungen zwischen den Transformatorkomponenten T1, T2 abbildet. Die Transformatorkomponenten T1, T2 bilden eine erste Gruppe von Knoten des Graphen 20. Die Statuszustände S1, S2 bilden eine zweite Gruppe von Knoten des Graphen 20. Im Folgenden soll nun auf die bereits zuvor genannten Wahrscheinlichkeitswerte eingegangen werden.

Zu jeder Statusgröße S1, S2 ist ein zugehöriger, erster Wahrscheinlichkeitswert (1. W-Wert) vorgesehen, dass die jeweilige Statusgröße S1, S2 einen falschen Zustand repräsentiert. In der Figur 2 ist eine erste Tabelle 48 dargestellt, aus der zu entnehmen ist, dass für die erste Statusgröße S1 ein zugehöriger, erster Wahrscheinlichkeitswert von 0,2 vorgesehen ist. Für die zweite Statusgröße S2 ist ein zugehöriger, erster Wahrscheinlichkeitswert von 0,3 vorgesehen. Der für die erste Statusgröße S1 vorgesehene, erste Wahrscheinlichkeitswert von 0,2 gibt also an, dass der jeweils von der Statusgröße S1 repräsentierte Zustand nicht richtig ist. Wird von der ersten Statusgröße S1 beispielsweise als Statuszustand der Normalzustand N repräsentiert, so besteht eine Wahrscheinlichkeit von 20%, dass der Normalzustand N nicht richtig ist, sondern dass der tatsächliche Zustand ein Anormalzustand A sein müsste. Für die zweite Statusgröße S2 und den zugehörigen, ersten Wahrscheinlichkeitswert von 0,3 gilt Entsprechendes.

Für jede Transformatorkomponente T1, T2 ist ein zugehöriger, zweiter Wahrscheinlichkeitswert (2. W-Wert) vorgesehen, dass in der jeweiligen Transformatorkomponente T1, T2 ein Fehler aufgetreten ist. Werden die erste Transformatorkomponente T1 beispielsweise durch die Primärspule und die zweite Transformatorkomponente T2 durch die Sekundärspule gebildet, so kann durch statistische Erhebungen festgestellt werden, dass beispielsweise eine Wahrscheinlichkeit von 20% besteht, dass die Primärspule einen Fehler aufweist und dass die Sekundärspule zu 30% einen Fehler aufweist. Zu jeder funktionalen Beziehung, die in dem Graphen 20 durch Pfeil repräsentiert ist, von einer der Transformatorkomponenten T1, T2 zu einer der Statusgrößen S1, S2 ist ein zugehöriger, dritter Wahrscheinlichkeitswert (3. W-Wert) vorgesehen, dass ein Fehler in der jeweiligen Transformatorkomponente T1, T2 einen Anormalzustand A der jeweiligen Statusgröße S1, S2 verursacht. Wenn also beispielsweise die Transformatorkomponente Ti in einem Anormalzustand A ist, dann ist der dritte Wahrscheinlichkeitswert in Bezug auf die Beziehung von der ersten Transformatorkomponente T1 zu der ersten Statusgröße S1 0,5. Es besteht also eine Wahrscheinlichkeit von 50%, dass wenn die Transformatorkomponente T1 den Anormalzustand A annimmt, dass der von der Statusgröße S1 repräsentierte Statuszustand der Anormalzustand A ist. Für die Beziehung zwischen der Transformatorkomponente T1 zu der Statusgröße S1 ist deshalb der zugehörige, dritte Wahrscheinlichkeitswert von 0,5 vorgesehen. Wie aus dem Graphen 20 zu erkennen ist, gibt es jedoch auch einen Fall von der Transformatorkomponente T1 zu der zweiten Statusgröße S2. Aus der dritten Tabelle 52 ist zu erkennen, dass wenn die erste Transformatorkomponente T1 in dem Anormalzustand A ist, dass basierend auf dem entsprechenden dritten Wahrscheinlichkeitswert eine Wahrscheinlichkeit von 90% besteht, dass der von der zweiten Statusgröße S2 repräsentierte Statuszustand ein Anormalzustand A ist. Die Vorrichtung 2 weist eine Speichereinheit 8 auf, wobei ein Datensatz von der Speichereinheit 8 gespeichert ist, der die ersten Wahrscheinlichkeitswerte, die zweiten Wahrscheinlichkeitswerte und die dritten Wahrscheinlichkeitswerte umfasst. Die Prozessoreinheit 6 der Vorrichtung 2 ist ausgebildet, um den Datensatz und/oder die Wahrscheinlichkeitswerte aus dem Datensatz aus der Speichereinheit 8 auszulesen.

Basierend auf den zuvor erläuterten Zusammenhängen zwischen den ersten, zweiten und dritten Wahrscheinlichkeitswerten sowie dem Graphen 20 kann die Prozessoreinheit 6 die entsprechenden Daten nutzen, um daraus ein Bayessches Netz 18 zu erzeugen. Es ist jedoch auch möglich, dass das Bayessche Netz 18 bereits besteht, und zwar auf dem gerichteten Graphen 20 und den zuvor genannten Wahrscheinlichkeitswerten. Das Bayessche Netz 18 kann somit eine spezielle Abbildung zwischen den Transformatorkomponenten 16 bzw. T1, T2 und den Statusgrößen S1, S2 repräsentieren. Das mittels der Signaleingangsschnittstelle 4 der Vorrichtung 2 empfangene Statussignal S des Messsystems 10 repräsentiert mehrere, unterschiedliche Statusgrößen, und zwar in diesem Fall tatsächlich vorliegende Statusgrößen. Basierend auf dem Bayesschen Netz 18 und den von den Statusgrößen des Messsignals repräsentierten Statuszuständen kann die Prozessoreinheit 6 deshalb für jede Transformatorkomponente 16 bzw. T1, T2 einen zugehörigen Fehlerwahrscheinlichkeitswert ermitteln, dass die jeweilige Transformatorkomponente 16 bzw. T1, T2 in einem Fehlerzustand ist. Jeder Fehlerwahrscheinlichkeitswert gibt also die Wahrscheinlichkeit an, dass die jeweilige Transformatorkomponente 16 bzw. T1, T2 tatsächlich in diesem Fehlerzustand ist. Die Prozessoreinheit 6 kann konfiguriert sein, die Fehlerwahrscheinlichkeitswerte durch Auswertung des Bayesschen Netzes 18 und unter Berücksichtigung der tatsächlichen Statuszustände zu ermitteln, und zwar beispielsweise mittels einer der folgenden Algorithmen: Sampling Algorithmus oder Variable Elimination Algorithmus. Die Prozessoreinheit 6 kann dazu ausgebildet und/oder konfiguriert sein, den jeweiligen Algorithmus auszuführen.

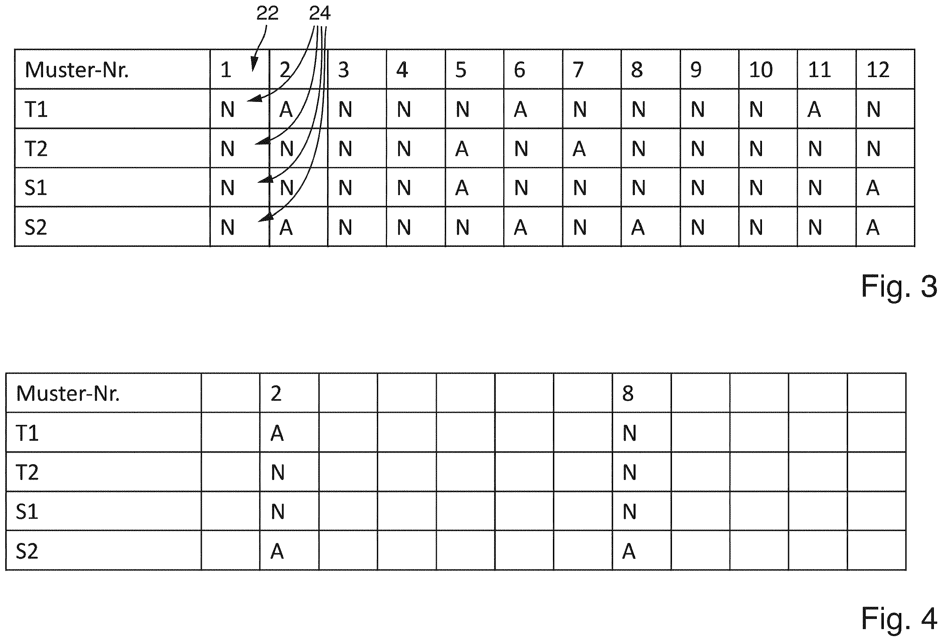

Insbesondere ist die Prozessoreinheit 6 konfiguriert, basierend auf dem Bayesschen Netz 18 und den ersten, zweiten und dritten Wahrscheinlichkeitswerten eine Vielzahl von Muster 22 zu erzeugen, wobei jedes Muster 22 für jede Statusgröße und für jede Transformatorkomponente T1, T2 bzw. 16 einen jeweils zugehörigen Musterzustand 24 als Normalzustand N oder als Anormalzustand A repräsentiert. In der Figur 3 ist eine Tabelle dargestellt, die insgesamt zwölf Muster 22, durchnummeriert von Nr. 1 bis Nr. 12, zeigt, wobei jedes Muster 22 zu jeder Transformatorkomponente T1, T2 und jeder Statusgröße S1, S2 einen Musterzustand 24 als Normalzustand (N) oder Anormalzustand (A) repräsentiert. Das Muster Nr. 1 repräsentiert somit die Musterzustände N, N, N, N und zwar in der Reihenfolge für: erste Transformatorkomponente T1, zweite Transformatorkomponente T2, erste Statusgröße S1 und zweite Statusgröße S2. In entsprechender Weise repräsentiert das zweite Muster Nr. 2 die Musterzustände A, N, N, A. Die weiteren Musterzustände sind aus der in Figur 3 dargestellten Tabelle zu entnehmen. Die Prozessoreinheit 6 erzeugt die Musterzustände 24 derart, dass die in den Tabellen 48, 50, 52 wiedergegebene Wahrscheinlichkeitswerte erfüllt sind. Um dies zu erreichen, sind in der Praxis oftmals eine große Vielzahl von Mustern mit zugehörigen Musterzuständen zu erzeugen. So ist es beispielsweise vorgesehen, dass die Prozessoreinheit 6 konfiguriert ist, eine Vielzahl von mindestens 10.000 Mustern 22 zu erzeugen. Die in Figur 3 dargestellte Vielzahl von Mustern 22 ist deshalb nur beispielhaft angegeben, und erhebt nicht den Anspruch, alle Bedingungen der Tabellen 48, 50, 52 zu erfüllen. Betrachtet man jedoch die Musterzustände 24 in den Mustern 22 für die erste Transformatorkomponente T1, so ergibt sich aus den Musterzuständen 24 für die ersten zehn Muster, dass zwei Musterzustände 24 den Anormalzustand A und die übrigen Musterzustände 24 den Normalzustand N repräsentieren. Daraus ergibt sich ein Wahrscheinlichkeitswert für den Anormalzustand A von 20% für die erste Transformatorkomponente T1. In der ersten Tabelle 48 der Figur 2 ist ein entsprechender Wahrscheinlichkeitswert für den Anormalzustand A in Bezug auf die erste Transformatorkomponente T1, nämlich ein Wahrscheinlichkeitswert von 0,2 dargestellt.

Von dem Messsystem 10 wird ein Statussignal S an die Signaleingangsschnittstelle 4 der Vorrichtung 2 übertragen, wobei die dadurch übertragenen Statusgrößen die tatsächlichen Statuszustände jeweils entweder als Normalzustand N oder als Anormalzustand A repräsentieren. Repräsentiert die erste Statusgröße S1 einen Normalzustand N und die zweite Statusgröße S2 einen Anormalzustand A, so können aus der Tabelle der Figur 3 genau zwei Muster 22 identifiziert werden, die die erste Statusgröße S1 als Normalzustand N und die zweite Statusgröße S2 als Anormalzustand A angeben. Dabei handelt es sich um das Muster mit der Nr. 2 und der Nr. 8. In der Figur 4 sind ausschließlich diese beiden Muster mit den Nr. 2 und 8 dargestellt. Die Prozessoreinheit 6 ist vorzugsweise konfiguriert, einen entsprechenden Verfahrensschritt auszuführen. Es ist deshalb vorgesehen, dass die Prozessoreinheit 6 konfiguriert ist, aus der Vielzahl der Muster 22 (Fig. 3) eine Referenzgruppe 26 von Mustern 22 (in dem Beispiel Muster Nr. 2, 8) zu bestimmen, sodass bei jedem Muster (Nr. 2 und Nr. 8) der Referenzgruppe 26 die zugehörigen Musterzustände 24 für die Statusgrößen S1, S2 mit den Statuszuständen der Statusgrößen des Statussignals S übereinstimmen. Außerdem ist die Prozessoreinheit 6 konfiguriert, für jede Transformatorkomponente T1, T2 einen zugehörigen Fehlerwahrscheinlichkeitswert basierend auf den Musterzuständen 24 für die Transformatorkomponenten T1, T2 aus den Mustern 22 (Nr. 2, 8) der Referenzgruppe 26 zu ermitteln, dass die jeweilige Transformatorkomponente T1, T2 in einem Anormalzustand A ist. Die Tabelle aus Figur 3 gibt die Muster (Muster Nr. 2, 8) der Referenzgruppe 26 an, die Statusgrößen S1, S2, aufweisen, die den tatsächlichen, mittels des Messsystems 10 ermittelten Statusgrößen S1, S2 entsprechen. Für jedes der Muster 22 der Referenzgruppe ist aber außerdem ein Musterzustand 24 für jedes der beiden Transformatorkomponenten T1, T2 angegeben. Aus dem Mittelwert der angegebenen Musterzustände für die jeweilige Transformatorkomponente T1, T2 kann der Fehlerwahrscheinlichkeitswert zu jeder der Transformatorkomponenten ermittelt werden. Zu der ersten Transformatorkomponente T1 gibt das Muster mit der Nr. 2 einen Anormalzustand A und das Muster mit der Nr. 8 einen Normalzustand N an. Der Mittelwert ist also 50%, sodass der Fehlerwahrscheinlichkeitswert 0,5 für die erste Transformatorkomponente T1 ist. Bei der zweiten Transformatorkomponente T2 sind in beiden Muster mit den Nr. 2, 8 der Musterzustand 24 als Normalzustand N angegeben, sodass der Mittelwert 100% Normalzustand N ist. Für die zweite Transformatorkomponente T2 beträgt der Fehlerwahrscheinlichkeitswert deshalb 0. Zusammenfassend ist deshalb festzustellen, dass, wenn das Messsystem 10 für die erste Zustandsgröße einen Normalzustand N und für die zweite Zustandsgröße einen Anormalzustand A feststellt, sodann mittels der Vorrichtung 2 für die erste Transformatorkomponente T1 ein Fehlerwahrscheinlichkeitswert von 0,5 und für die zweite Transformatorkomponente T2 ein zugehöriger Fehlerwahrscheinlichkeitswert von 0 ermittelt wird. Das bedeutet, dass die zweite Transformatorkomponente T2 in einem Normalzustand N ist und dass die erste Transformatorkomponente T1 zu 50% in einem Fehlerzustand bzw. Anormalzustand A ist. Der Fehlerzustand oder Anormalzustand A können Synonyme sein.

Wie aus der Figur 1 schematisch zu entnehmen ist, kann die Vorrichtung 2 mit eine separaten über eine Signalleitung mit einer Anzeigevorrichtung 30 gekoppelt sein. Alternativ oder ergänzend kann die Vorrichtung 2 eine integrierte Anzeigeeinheit 34 aufweisen. Die Anzeigeeinheit 34 kann mit der Prozessoreinheit 6 gekoppelt sein. Die Prozessoreinheit 6 kann dazu konfiguriert und/oder ausgebildet sein, die Anzeigeeinheit 34 derart zu steuern, sodass von der Anzeigeeinheit 34 ein Bild wiedergegeben wird, das die ermittelten Fehlerwahrscheinlichkeitswerte graphisch darstellt und die zugehörigen Transformatorkomponenten 16 indiziert und/oder bezeichnet. Dadurch kann eine Person, die die Anzeigeeinheit 34 der Vorrichtung 2 betrachtet, unmittelbar erkennen, welche der Transformatorkomponenten 16 mit welcher Wahrscheinlichkeit einen Anormalzustand A bzw. Fehlerzustand hat. Eine derartige Erkenntnis lässt sich der Erfahrung nach aus den Statuszuständen, die von dem Messsystem 10 erzeugt werden, nicht unmittelbar und direkt ableiten.

Es ist möglich, dass die Vorrichtung 2 eine Ausgangssignalschnittstelle 36 aufweist, wobei die Vorrichtung 2 ausgebildet ist, ein Ausgangssignal Q zu erzeugen, das zumindest den größten der ermittelten Fehlerwahrscheinlichkeitswerte und die zugehörige Transformatorkomponente 16 repräsentiert. Außerdem ist die Vorrichtung 2 vorzugsweise derart ausgebildet und/oder konfiguriert, die Signalausgangsschnittstelle 36 derart zu steuern, sodass das Ausgangsignal Q mittels der Signalausgangsschnittstelle 36 übertragen, insbesondere gesendet, wird, und zwar vorzugsweise an die Anzeigevorrichtung 30.

Bereits zuvor wurde erläutert, dass die Vorrichtung 2 ein Teil eines Systems 28 sein kann, wobei das System 28 neben der Vorrichtung 2 außerdem die Anzeigeeinheit 30 mit einem Bildschirm aufweist. Die Vorrichtung 2 kann dazu ausgebildet und/oder konfiguriert sein, dass Ausgangssignal Q mittels der Signalausgangsschnittstelle 36 an die Anzeigeeinheit 30 zu übertragen, sodass von der Anzeigeeinheit 30 ein Bild angezeigt wird, das den Fehlerwahrscheinlichkeitswert graphisch darstellt und die zugehörige Transformatorkomponente 16 indiziert und/oder bezeichnet. Hierzu kann die Anzeigeeinheit 30 entsprechend ausgebildet sein. Zwischen der Signalausgangsschnittstelle 36 und der Anzeigeeinheit 30 kann eine Signalverbindung, insbesondere eine kabelgebundene und/oder funkgebundene Signalverbindung bestehen.

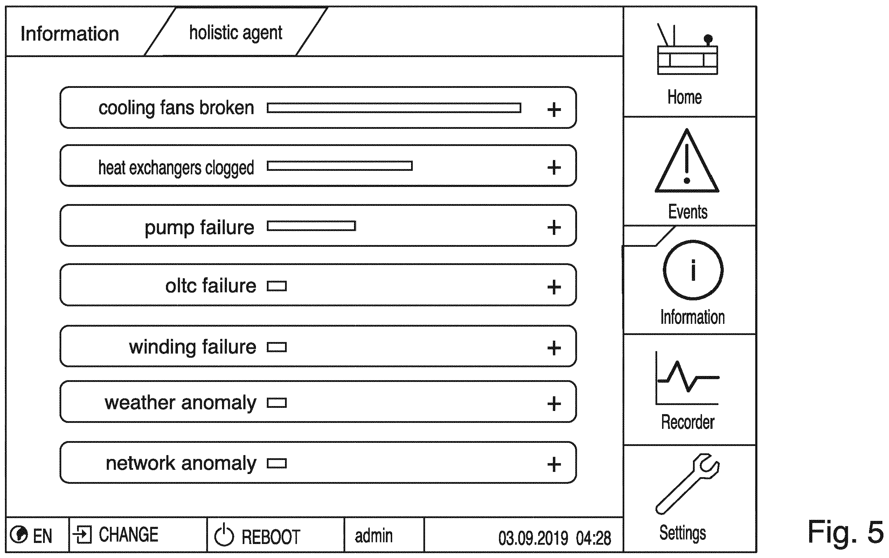

In der Praxis besteht oftmals Interesse an der Transformatorkomponente 16, für die der größte Fehlerwahrscheinlichkeitswert ermittelt wurde, da in diesem Fall anzunehmen ist, dass die zugehörige Transformatorkomponente 16 sehr wahrscheinlich in einem Anormalzustand A ist. Der Fehlerwahrscheinlichkeitswert repräsentiert jedoch eine Wahrscheinlichkeit, dass die jeweilige Transformatorkomponente 16 in einem Anormalzustand A ist. Es verbleibt also eine Restwahrscheinlichkeit, dass die jeweilige Transformatorkomponente 16 nicht in dem Anormalzustand A, sondern in einem Normalzustand N ist. In der Praxis besteht deshalb oftmals auch Interesse an dem zweitgrößten oder drittgrößten Fehlerwahrscheinlichkeitswert. Es ist deshalb bevorzugt vorgesehen, dass die Vorrichtung 2 ausgebildet ist, das Ausgangssignal Q derart zu erzeugen, dass das Ausgangssignal Q zumindest die zwei oder drei größten Fehlerwahrscheinlichkeitswerte und die zugehörigen Transformatorkomponenten 16 repräsentiert. Die Anzeigeeinheit 30 des Systems 28 ist vorzugsweise dazu ausgebildet, ein die Transformatorkomponenten 16 und zugehörige Fehlerwahrscheinlichkeitswerte indizierendes, zweites Bild auf dem Bildschirm der Auswerteeinheit 30 basierend auf dem Ausgangssignal Q anzuzeigen. So kann die Anzeigeeinheit 30 ausgebildet sein, dass das von dem Bildschirm angezeigte Bild die von dem Ausgangssignal Q repräsentierten Transformatorkomponenten 16 listenförmig und die zugehörigen Fehlerwahrscheinlichkeitswerte durch unterschiedliche Farben und/oder Balken qualitativ anzuzeigt. In der Figur 5 ist das von dem Bildschirm wiedergegebene Bildschirmbild beispielhaft dargestellt, wobei dieses Bildschirmbild das zuvor genannte Bild umfasst, indem die Transformatorkomponenten 16 listenförmig und die zugehörigen Fehlerwahrscheinlichkeitswerte durch (farbige) Balken und Länge der Balken qualitativ dargestellt sind. Je länger der Balken ist, desto größer ist die für die jeweilige Transformatorkomponente 16 ermittelte Fehlerwahrscheinlichkeit. Die Transformatorkomponenten 16 sind entsprechend der Größe der Fehlerwahrscheinlichkeitswerte aufgelistet, wobei die Transformatorkomponente 16 mit dem größten Fehlerwahrscheinlichkeitswert an oberster Stelle angeordnet ist. Aus dieser listenförmigen Darstellung der Transformatorkomponenten 16 und der zugehörigen Fehlerwahrscheinlichkeitswerte kann eine Person auf einen Blick erkennen, welche der Transformatorkomponenten 16 am wahrscheinlichsten in einem Anormalzustand A ist, und gleichzeitig aus dem Vergleich der Farbe und/oder Länge der Balken erkennen, welche der anderen Transformatorkomponenten 16 ebenfalls mit einer gewissen Wahrscheinlichkeit in einem Anormalzustand A ist. Dies erleichtert die Wartung und/oder Fehlerbehebung in einem Leistungstransformator 12.

Das in Figur 1 schematisch dargestellte System 28 umfasst die Vorrichtung 2 und die Anzeigeeinheit 30. Es kann vorgesehen sein, dass das System 28 zusätzlich das Messsystem 10 mit den zugehörigen Sensoren 14 umfasst. Dabei kann die Anzeigeeinheit 30 mit dem Messsystem 10 verbunden sein oder die Anzeigeeinheit 30 kann in das Messsystem 10 integriert sein. Darüber hinaus ist es möglich, dass das System 28 zusätzlich noch den Leistungstransformator 12 umfasst.

Das Messsystem 10 kann einen ersten Sensor 14 aufweisen, der zur Erfassung von einer Temperatur der Kühlflüssigkeit im Tank des Leistungstransformators 12 ausgebildet ist. Ein weiterer Sensor 14 kann zur Erfassung einer auf die Primärspule wirkenden, mechanischen Spannung oder mechanischen Kraft ausgebildet sein. Ein dritter Sensor 14 des Messsystems 10 kann zur Erfassung einer Spannung zwischen den Anschlüssen 44 an der Primärseite des Leistungstransformators 12 ausgebildet sein. Ein vierter Sensor 14 des Messsystems kann zur Erfassung von Verlustfaktor und/oder Kapazität einer oder mehrerer Durchführungen des Leistungstransformators 12 ausgebildet sein. Ein fünfter Sensor 14 des Messsystems 10 kann zur Erfassung akustischer Signale, die bei der Betätigung eines Stufenschalters des Leistungstransformators 12 entstehen, ausgebildet sein. Darüber hinaus sind auch andere Sensoren oder weitere Sensoren 14 für das Messsystem 10 möglich.

Außerdem ist es bevorzugt vorgesehen, dass die Vorrichtung 2 ausgebildet ist, die Fehlerwahrscheinlichkeitswerte für die Transformatorkomponenten 16 periodisch erneut zu erfassen, und zwar vorzugsweise immer nachdem ein Statussignal S mit neuen, mehreren, unterschiedlichen Statusgrößen von dem Messsystem 10 empfangen sind. Auch das Messsystem 10 kann zur periodischen Auswertung der von den zugehörigen Sensoren 14 erfassten Eigenschaften des Leistungstransformators 12 ausgebildet sein. Nach jedem periodischen Erfassen der Eigenschaften mittels der zugehörigen Sensoren 14 kann das Messsystem 10 ein Statussignal S an die Signaleingangsschnittstelle 4 der Vorrichtung 2 übertragen. Anschließend findet die Ermittlung der Fehlerwahrscheinlichkeiten für die Transformatorkomponenten 16 mittels der Prozessoreinheit 6 statt. Darüber hinaus kann eine Aktualisierung des Ausgangssignals Q basierend auf den jeweils zuletzt ermittelten Fehlerwahrscheinlichkeiten mittels der Prozessoreinheit 6 erfolgen, sodass auf der Anzeigevorrichtung immer ein aktuelles Bild ausgegeben wird, welche der Transformatorkomponenten 16 die höchste Wahrscheinlichkeit eines Fehlers aufweisen

Ergänzend sei darauf hingewiesen, dass "aufweisend" keine anderen Elemente oder Schritte ausschließt und "ein" oder "eine" keine Vielzahl ausschließt. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugszeichen in den Ansprüchen sind nicht als Einschränkung anzusehen.

### BEZUGSZEICHENLISTE

- A: Anormalzustand
- Q: Ausgangssignal
- S: Statussignal
- N: Normalzustand
- S1: Statusgröße
- S2: Statusgröße
- T1: Transformatorkomponente
- T2: Transformatorkomponente

- 2: Vorrichtung
- 4: Signaleingangsschnittstelle der Vorrichtung
- 6: Prozessoreinheit
- 8: Speichereinheit
- 10: Messsystem
- 12: Leistungstransformator
- 14: Sensor
- 16: Transformatorkomponente
- 18: Bayessches Netz
- 20: Graph
- 22: Muster
- 24: Musterzustand
- 26: Referenzgruppe
- 28: System
- 30: Anzeigeeinheit
- 34: Anzeigeeinheit der Vorrichtung
- 36: Signalausgangsschnittstelle der Vorrichtung
- 38: Eingangsschnittstelle
- 40: Ausgangsschnittstelle
- 42: Auswerteeinheit
- 44: Anschlüsse Primärseite
- 46: Anschlüsse Sekundärseite
- 48: erste Tabelle (1·W-Werte)
- 50: zweite Tabelle (2·W-Werte)
- 52: dritte Tabelle (3·W-Werte)

## Patentansprüche

1. **Vorrichtung** (2) zur Ermittlung eines Fehlerwahrscheinlichkeitswerts für eine Transformatorkomponente (16), aufweisend
eine Signaleingangsschnittstelle (4),
eine Prozessoreinheit (6), und
eine Speichereinheit (8),
wobei die Signaleingangsschnittstelle (4) zur direkten oder indirekten Kopplung mit einem Messsystem (10) für einen Leistungstransformator (12) ausgebildet ist, wobei das Messsystem (10) mehrere Sensoren (14) aufweist, die jeweils zur Erfassung einer physischen und/oder chemischen Eigenschaft des Leistungstransformators (12) ausgebildet sind, wobei der Leistungstransformator (12) mehrere Transformatorkomponenten (16) aufweist, und wobei jeder Sensor (14) mit mindestens einer der Transformatorkomponenten (16) des Leistungstransformators (12) über eine jeweils zugehörige direkte oder indirekte Verbindung gekoppelt ist, sodass die von dem jeweiligen Sensor (14) erfasste Eigenschaft des Leistungstransformators (12) von mindestens einer der Transformatorkomponenten (16) beeinflusst ist;
wobei die Signaleingangsschnittstelle (14) zum Empfang eines Statussignals S des Messystems (10) ausgebildet ist, wobei das Statussignal S mehrere, unterschiedliche Statusgrößen S1, S2 repräsentiert, wobei jeder Statusgröße S1, S2 mindestens einer der Sensoren (14) zugeordnet ist, sodass jede Statusgröße S1, S2 in einer funktionalen Beziehung mit mindestens einer der Transformatorkomponenten (16) ist, wobei jede Statusgröße S1, S2 einen Statuszustand der von dem mindestens einen zugeordneten Sensor (14) erfassten Eigenschaft des Leistungstransformators (12) als Normalzustand N oder als Anormalzustand A repräsentiert;
wobei
ein Datensatz von der Speichereinheit (8) gespeichert ist, wobei der Datensatz zu jeder Statusgröße S1, S2 einen zugehörigen, ersten Wahrscheinlichkeitswert aufweist, dass die jeweilige Statusgröße S1, S2 einen falschen Zustand repräsentiert, wobei der Datensatz zu jeder Transformatorkomponente (16) einen zugehörigen, zweiten Wahrscheinlichkeitswert aufweist, dass in der jeweiligen Transformatorkomponente (16) ein Fehler aufgetreten ist, wobei der Datensatz zu jeder der funktionalen Beziehungen von einer der Transformatorkomponenten (16) zu einem der Statusgrößen S1, S2 einen zugehörigen, dritten Wahrscheinlichkeitswert aufweist, dass ein Fehler in der jeweiligen Transformatorkomponente (16) einen Anormalzustand A der jeweiligen Statusgröße S1, S2 verursacht; und
wobei die Prozessoreinheit (6) konfiguriert ist, für jede Transformatorkomponente (16) einen zugehörigen Fehlerwahrscheinlichkeitswert basierend auf einem Bayesschen Netz (18), das einen gerichteten Graphen (20) von den Transformatorkomponenten (16) zu den Statusgrößen S1, S2 basierend auf den ersten, zweiten und dritten Wahrscheinlichkeitswerten repräsentiert, sowie basierend auf den von den Statusgrößen S1, S2 repräsentierten Statuszuständen zu ermitteln, dass die jeweilige Transformatorkomponente (16) in einem Fehlerzustand ist;
**dadurch gekennzeichnet, dass** das Bayessche Netz (18) als ein bipartiter Graph (20) ausgebildet ist, der eine erste Gruppe von Knoten, eine zweite Gruppe von Knoten und funktionale Beziehungen von der ersten Gruppe von Knoten zur zweiten Gruppe von Knoten repräsentiert, wobei die erste Gruppe von Knoten durch die ersten Wahrscheinlichkeitswerte, die zweite Gruppe von Knoten durch die zweiten Wahrscheinlichkeitswerte und die funktionalen Beziehungen durch die dritten Wahrscheinlichkeitswerte bestimmt sind.

2. Vorrichtung (2) nach dem vorhergehenden Anspruch, **dadurch gekennzeichnet, dass** die Prozessoreinheit (6) konfiguriert ist, basierend auf dem Bayesschen Netz (18), das einen gerichteten Graphen (20) von den Transformatorkomponenten (16) zu den Statusgrößen S1, S2 basierend auf den ersten, zweiten und dritten Wahrscheinlichkeitswerten repräsentiert, eine Vielzahl von Mustern (22) zu erzeugen, wobei jedes Muster (22) für jede Statusgröße S1, S2 und für jede Transformatorkomponente (16) einen jeweils zugehörigen Musterzustand (24) als Normalzustand N oder Anormalzustand A repräsentiert; wobei die Prozessoreinheit (6) konfiguriert ist, aus der Vielzahl der Muster (22) eine Referenzgruppe (26) von Mustern (22) zu bestimmen, so dass bei jedem Muster (22) der Referenzgruppe (26) die zugehörigen Musterzustände (24) für die Statusgrößen S1, S2 mit den Statuszuständen der Statusgrößen S1, S2 des Statussignals S übereinstimmen; und wobei die Prozessoreinheit (6) konfiguriert ist, für jede Transformatorkomponente (16) einen zugehörigen Fehlerwahrscheinlichkeitswert basierend auf den Musterzuständen (24) für die Transformatorkomponenten (16) aus den Mustern (22) der Referenzgruppe (26) zu ermitteln, dass die jeweilige Transformatorkomponente (16) in einem Anormalzustand A ist.

3. Vorrichtung (2) nach einem der vorhergehenden Ansprüche, **dadurch gekennzeichnet, dass** die Vorrichtung (2) eine Ausgangsschnittstelle (40) aufweist, wobei die Vorrichtung (2) ausgebildet ist, ein Ausgangssignal Q zu erzeugen, das zumindest den größten der Fehlerwahrscheinlichkeitswerte und die zugehörige Transformatorkomponente (16) repräsentiert, und wobei die Vorrichtung (2) ausgebildet ist, das Ausgangssignal Q mittels der Signalausgangsschnittstelle (36) zu übertragen.

4. Vorrichtung (2) nach dem vorhergehenden Anspruch, **dadurch gekennzeichnet, dass** die Vorrichtung (2) ausgebildet ist, das Ausgangssignal Q derart zu erzeugen, dass das Ausgangssignal Q zumindest die zwei oder drei größten Fehlerwahrscheinlichkeitswerte und die zugehörigen Transformatorkomponenten (16) repräsentiert.

5. Vorrichtung (2) nach einem der vorhergehenden Ansprüche, **dadurch gekennzeichnet, dass** die vom Statussignal S repräsentierten Statusgrößen S1, S2 ternäre Statusgrößen sind, die jeweils genau einen Statuszustand aus der folgenden Gruppe der möglichen Statuszustände repräsentieren: Normalzustand N, Anormalzustand A oder Nichtinstallationszustand.

6. Vorrichtung (2) nach dem vorhergehenden Anspruch, **dadurch gekennzeichnet, dass** die Prozessoreinheit (6) konfiguriert ist, das Bayessche Netz (18) basierend auf dem Datensatz zu erzeugen.

7. Vorrichtung (2) nach einem der vorhergehenden Ansprüche, **dadurch gekennzeichnet, dass** die Prozessoreinheit (6) konfiguriert ist, die Muster (22) mittels eines Wahrscheinlichkeitsgewichtungsalgorithmus (likelihood weighting algorithm) zu erzeugen.

8. Vorrichtung (2) nach einem der vorhergehenden Ansprüche 4 bis 7, **dadurch gekennzeichnet, dass** die Prozessoreinheit (6) ausgebildet ist, das Ausgangssignal Q derart zu erzeugen, sodass das Ausgangssignal Q die zugehörige Fehlerwahrscheinlichkeitswerte und Transformatorkomponenten (16) als ein erstes Bild repräsentiert, in dem die Fehlerwahrscheinlichkeitswerte graphisch dargestellt und die Transformatorkomponenten (16) indiziert und/oder bezeichnet sind.

9. **System** (28), aufweisend:
eine Vorrichtung (2) nach einem der vorhergehenden Ansprüche 4 bis 7, und
eine Anzeigeeinheit (30) mit einem Bildschirm,
wobei die Signalausgangsschnittstelle (36) der Vorrichtung (2) über eine direkte oder indirekte, erste Signalverbindung mit der Anzeigeeinheit (30) gekoppelt ist, um das Ausgangssignal Q an die Anzeigeeinheit (30) zu übertragen, und
wobei die Anzeigeeinheit (30) ausgebildet ist, ein die Transformatorkomponenten (16) und zugehörigen Fehlerwahrscheinlichkeitswerte indizierendes, zweites Bild auf dem Bildschirm basierend auf dem Ausgangssignal Q anzuzeigen.

10. System (28) nach dem vorhergehenden Anspruch, **dadurch gekennzeichnet, dass** die Anzeigeeinheit (30) ausgebildet ist, so dass das zweite Bild die von dem Ausgangssignal Q repräsentierten Transformatorkomponenten (16) listenförmig und die zugehörigen Fehlerwahrscheinlichkeitswerte durch unterschiedliche Farben und/oder Balken qualitativ anzeigt.

11. System (28) nach einem der vorhergehenden Ansprüche 9 bis 10, **dadurch gekennzeichnet, dass** das System (28) ein Messsystem (10) für den Leistungstransformator (12) aufweist, wobei das Messsystem (10) mit der Signaleingangsschnittstelle (4) der Vorrichtung (2) gekoppelt ist, um das Statussignal S an die Signaleingangsschnittstelle (4) zu übertragen, wobei das Messsystem (10) mehrere Sensoren (14) aufweist, die jeweils zur Erfassung der physischen und/oder chemischen Eigenschaft des Leistungstransformators (12) ausgebildet sind, wobei der Leistungstransformator (12) mehrere Transformatorkomponenten (16) aufweist, und wobei jeder Sensor (14) mit mindestens einer der Transformatorkomponenten (16) des Leistungstransformators (12) über eine jeweils zugehörige direkte oder indirekte Verbindung gekoppelt ist, so dass die von dem jeweiligen Sensor (14) erfasste Eigenschaft des Leistungstransformators (12) von mindestens einer der Transformatorkomponenten (16) beeinflusst ist.

12. System (28) nach dem vorhergehenden Anspruch, **dadurch gekennzeichnet, dass** das Messsystem (10) ausgebildet ist, mindestens zwei der folgenden Eigenschaften des Leistungstransformators (12) sensorisch zu erfassen: Gas aus Kohlenwasserstoffketten im flüssigen Isoliermedium, Wasser im flüssigen Isoliermedium, Füllstand des flüssigen Isoliermedium, elektrische Spannung, elektrischer Strom, Wicklungsspannkraft, Drehgeschwindigkeit eines Ventilators, elektrische Leistung des Ventilatormotors, Lautstärke des Ventilators, Motordrehmoment eines Stufenschalters, Schaltsequenz des Stufenschalters, Hot-Spot-Temperatur, Top-Oil-Temperatur, Verlustfaktor von einer oder mehreren Durchführungen des Leistungstransformators (12), Kapazität von einer oder mehreren Durchführungen des Leistungstransformators (12), akustische Signale eines Stufenschalters, Vibroakustische Intensität, und Funktionsfähigkeit des Luftentfeuchters.

13. System (28) nach einem der vorhergehenden Ansprüche 9 bis 12, **dadurch gekennzeichnet, dass** die Anzeigeeinheit (30) einen Teil des Messsystems (10) bildet.

14. System (28) nach einem der vorhergehenden Ansprüche 9 bis 13, **dadurch gekennzeichnet, dass** das System (28) ein Fernüberwachungssystem aufweist, wobei die Signalausgangsschnittstelle (36) der Vorrichtung (2) über eine direkte oder indirekte, zweite Signalverbindung mit dem Fernüberwachungssystem gekoppelt ist, um das Ausgangssignal Q an das Fernüberwachungssystem zu übertragen.

15. System (28) nach dem vorhergehenden Anspruch, **dadurch gekennzeichnet, dass** das Fernüberwachungssystem Cloud-basiert ausgebildet ist.

16. System (28) nach einem der vorhergehenden Ansprüche 14 bis 15, **dadurch gekennzeichnet, dass** die Anzeigeeinheit (30) einen Teil des Fernüberwachungssystems bildet.

17. System (28) nach einem der vorhergehenden Ansprüche 9 bis 16, **dadurch gekennzeichnet, dass** das System (28) den Leistungstransformator (12) umfasst.

## Claims

1. **Device** (2) for determining a fault probability value for a transformer component (16), comprising
a signal input interface (4),
a processor unit (6), and
a storage unit (8),
the signal input interface (4) being designed for direct or indirect coupling to a measurement system (10) for a power transformer (12), the measurement system (10) having a plurality of sensors (14) which are each designed to detect a physical and/or chemical property of the power transformer (12), the power transformer (12) having a plurality of transformer components (16), and wherein each sensor (14) is coupled to at least one of the transformer components (16) of the power transformer (12) via a respectively associated direct or indirect connection, so that the property of the power transformer (12) detected by the respective sensor (14) is influenced by at least one of the transformer components (16);
the signal input interface (14) being designed to receive a status signal S of the measuring system (10), the status signal S representing a plurality of different status variables S1, S2, each status variable S1, S2 being assigned to at least one of the sensors (14), so that each status variable S1, S2 is in a functional relationship with at least one of the transformer components (16), wherein each status variable S1, S2 represents a status state of the property of the power transformer (12) detected by the at least one associated sensor (14) as a normal state N or as an abnormal state A;
whereby
a data set is stored by the memory unit (8), the data set having an associated first probability value for each status variable S1, S2, that the respective status variable S1, S2 represents an incorrect state, the data set having an associated second probability value for each transformer component (16), that an error has occurred in the respective transformer component (16), wherein the data set for each of the functional relationships of one of the transformer components (16) to one of the status variables S1, S2 has an associated third probability value that an error in the respective transformer component (16) causes an abnormal state A of the respective status variable S1, S2; and
wherein the processor unit (6) is configured to determine for each transformer component (16) an associated fault probability value based on a Bayesian network (18) representing a directed graph (20) from the transformer components (16) to the status variables S1, S2 based on the first, second and third probability values, and based on the status states represented by the status variables S1, S2 that the respective transformer component (16) is in a fault state;
**characterized in that** the Bayesian network (18) is formed as a bipartite graph (20) representing a first set of nodes, a second set of nodes, and functional relationships from the first set of nodes to the second set of nodes, the first set of nodes being determined by the first probability values, the second set of nodes being determined by the second probability values, and the functional relationships being determined by the third probability values.

2. The device (2) according to the preceding claim, **characterized in that** the processor unit (6) is configured to generate a plurality of patterns (22) based on the Bayesian network (18) representing a directed graph (20) from the transformer components (16) to the status variables S1, S2 based on the first, second and third probability values, each pattern (22) for each status variable S1, S2 and for each transformer component (16) having a respective associated pattern value, second and third probability values, to generate a plurality of patterns (22), each pattern (22) representing for each status variable S1, S2 and for each transformer component (16) a respective associated pattern state (24) as normal state N or abnormal state A; wherein the processor unit (6) is configured to determine a reference group (26) of patterns (22) from the plurality of patterns (22), so that for each pattern (22) of the reference group (26) the associated pattern states (24) for the status variables S1, S2 correspond to the status states of the status variables S1, S2 of the status signal S; and wherein the processor unit (6) is configured to determine for each transformer component (16) an associated fault probability value based on the pattern states (24) for the transformer components (16) from the patterns (22) of the reference group (26) that the respective transformer component (16) is in an abnormal state A.

3. Device (2) according to one of the preceding claims, **characterized in that** the device (2) has an output interface (40), wherein the device (2) is designed to generate an output signal Q which represents at least the largest of the error probability values and the associated transformer component (16), and wherein the device (2) is designed to transmit the output signal Q by means of the signal output interface (36).

4. Device (2) according to the preceding claim, **characterized in that** the device (2) is designed to generate the output signal Q in such a way that the output signal Q represents at least the two or three largest error probability values and the associated transformer components (16).

5. Device (2) according to one of the preceding claims, **characterized in that** the status variables S1, S2 represented by the status signal S are ternary status variables which each represent exactly one status state from the following group of possible status states: Normal state N, Abnormal state A or Non-installation state.

6. Device (2) according to the preceding claim, **characterized in that** the processor unit (6) is configured to generate the Bayesian network (18) based on the data set.

7. The device (2) according to any one of the preceding claims, **characterized in that** the processing unit (6) is configured to generate the patterns (22) by means of a likelihood weighting algorithm.

8. Device (2) according to one of the preceding claims 4 to 7, **characterized in that** the processor unit (6) is designed to generate the output signal Q in such a way that the output signal Q represents the associated error probability values and transformer components (16) as a first image in which the error probability values are graphically represented and the transformer components (16) are indexed and/or designated.

9. **System** (28), comprising: A device (2) according to any one of the preceding claims 4 to 7, and
a display unit (30) with a screen,
wherein the signal output interface (36) of the device (2) is coupled to the display unit (30) via a direct or indirect first signal connection to transmit the output signal Q to the display unit (30), and
wherein the display unit (30) is designed to display a second image on the screen indicating the transformer components (16) and associated fault probability values based on the output signal Q.

10. System (28) according to the preceding claim, **characterized in that** the display unit (30) is designed so that the second image displays the transformer components (16) represented by the output signal Q in list form and the associated error probability values qualitatively by means of different colors and/or bars.

11. System (28) according to one of the preceding claims 9 to 10, **characterized in that** the system (28) comprises a measuring system (10) for the power transformer (12), wherein the measuring system (10) is coupled to the signal input interface (4) of the device (2) in order to transmit the status signal S to the signal input interface (4), wherein the measuring system (10) comprises a plurality of sensors (14), which are each designed to detect the physical and/or chemical property of the power transformer (12), wherein the power transformer (12) has a plurality of transformer components (16), and wherein each sensor (14) is coupled to at least one of the transformer components (16) of the power transformer (12) via a respectively associated direct or indirect connection, so that the property of the power transformer (12) detected by the respective sensor (14) is influenced by at least one of the transformer components (16).

12. System (28) according to the preceding claim, **characterized in that** the measuring system (10) is designed to detect at least two of the following properties of the power transformer (12) by sensors: Gas from hydrocarbon chains in the liquid insulating medium, water in the liquid insulating medium, filling level of the liquid insulating medium, electrical voltage, electrical current, winding tension force, rotational speed of a fan, electrical power of the fan motor, volume of the fan, motor torque of a tap changer, switching sequence of the tap changer, hot spot temperature, top oil temperature, dissipation factor of one or more bushings of the power transformer (12), capacitance of one or more bushings of the power transformer (12), acoustic signals of a tap changer, vibroacoustic intensity, and functionality of the dehumidifier.

13. System (28) according to one of the preceding claims 9 to 12, **characterized in that** the display unit (30) forms part of the measuring system (10).

14. The system (28) according to any one of the preceding claims 9 to 13, **characterized in that** the system (28) comprises a remote monitoring system, wherein the signal output interface (36) of the device (2) is coupled to the remote monitoring system via a direct or indirect second signal connection to transmit the output signal Q to the remote monitoring system.

15. System (28) according to the preceding claim, **characterized in that** the remote monitoring system is cloud-based.

16. System (28) according to any one of the preceding claims 14 to 15, **characterized in that** the display unit (30) forms part of the remote monitoring system.

17. The system (28) according to any one of the preceding claims 9 to 16, **characterized in that** the system (28) comprises the power transformer (12).

## Revendications

1. **Dispositif** (2) pour déterminer une valeur de probabilité d'erreur pour un composant de transformateur (16), comprenant
une interface d'entrée de signal (4),
une unité de traitement (6), et
une unité de mémoire (8),
l'interface d'entrée de signal (4) étant conçue pour être couplée directement ou indirectement à un système de mesure (10) pour un transformateur de puissance (12), le système de mesure (10) comportant plusieurs capteurs (14) qui sont conçus chacun pour détecter une propriété physique et/ou chimique du transformateur de puissance (12), le transformateur de puissance (12) comportant plusieurs composants de transformateur (16), et dans lequel chaque capteur (14) est couplé à au moins l'un des composants de transformateur (16) du transformateur de puissance (12) par l'intermédiaire d'une liaison directe ou indirecte respectivement associée, de sorte que la propriété du transformateur de puissance (12) détectée par le capteur respectif (14) est influencée par au moins l'un des composants de transformateur (16) ;
l'interface d'entrée de signal (14) étant conçue pour recevoir un signal d'état S du système de mesure (10), le signal d'état S représentant plusieurs grandeurs d'état S1, S2 différentes, au moins un des capteurs (14) étant associé à chaque grandeur d'état S1, S2, de sorte que chaque grandeur d'état S1, S2 est dans une relation fonctionnelle avec au moins l'un des composants du transformateur (16), chaque grandeur d'état S1, S2 représentant un état d'état de la propriété du transformateur de puissance (12) détectée par le au moins un capteur (14) associé, comme état normal N ou comme état anormal A ;
où
un ensemble de données est mémorisé par l'unité de mémoire (8), l'ensemble de données présentant, pour chaque grandeur d'état S1, S2, une première valeur de probabilité associée, que la grandeur d'état respective S1, S2 représente un état incorrect, l'ensemble de données présentant, pour chaque composant de transformateur (16), une deuxième valeur de probabilité associée, qu'une erreur est survenue dans le composant de transformateur respectif (16), l'ensemble de données présentant, pour chacune des relations fonctionnelles de l'un des composants de transformateur (16) à l'une des grandeurs d'état S1, S2, une troisième valeur de probabilité associée, qu'une erreur dans le composant de transformateur respectif (16) provoque un état anormal A de la grandeur d'état respective S1, S2 ; et
dans lequel l'unité de traitement (6) est configurée pour déterminer, pour chaque composant de transformateur (16), une valeur de probabilité d'erreur associée sur la base d'un réseau bayésien (18) représentant un graphe orienté (20) allant des composants de transformateur (16) aux grandeurs d'état S1, S2 sur la base des première, deuxième et troisième valeurs de probabilité, et sur la base des états d'état représentés par les grandeurs d'état S1, S2, que le composant de transformateur respectif (16) est dans un état d'erreur ;
**caractérisé en ce que** le réseau bayésien (18) est formé comme un graphe biparti (20) représentant un premier groupe de noeuds, un deuxième groupe de noeuds et des relations fonctionnelles du premier groupe de noeuds au deuxième groupe de noeuds, le premier groupe de noeuds étant déterminé par les premières valeurs de probabilité, le deuxième groupe de noeuds par les deuxièmes valeurs de probabilité et les relations fonctionnelles par les troisièmes valeurs de probabilité.

2. Dispositif (2) selon la revendication précédente, **caractérisé en ce que** l'unité de traitement (6) est configurée pour générer, sur la base du réseau bayésien (18) représentant un graphe orienté (20) des composants de transformateur (16) vers les grandeurs d'état S1, S2, sur la base des première, deuxième et troisième valeurs de probabilité, un graphe orienté (20) des composants de transformateur (16) vers les grandeurs de probabilité, deuxième et troisième valeurs de probabilité, une pluralité de modèles (22), chaque modèle (22) représentant, pour chaque grandeur d'état S1, S2 et pour chaque composant de transformateur (16), un état de modèle (24) respectivement associé en tant qu'état normal N ou état anormal A ; l'unité de traitement (6) étant configurée pour déterminer un groupe de référence (26) de modèles (22) à partir de la pluralité de modèles (22), de sorte que pour chaque modèle (22) du groupe de référence (26), les états de modèle (24) associés pour les grandeurs d'état S1, S2 coïncident avec les états d'état des grandeurs d'état S1, S2 du signal d'état S ; et dans lequel l'unité de traitement (6) est configurée pour déterminer, pour chaque composant de transformateur (16), une valeur de probabilité d'erreur associée basée sur les états de modèle (24) pour les composants de transformateur (16) à partir des modèles (22) du groupe de référence (26), que le composant de transformateur respectif (16) est dans un état anormal A.

3. Dispositif (2) selon l'une quelconque des revendications précédentes, **caractérisé en ce que** le dispositif (2) comprend une interface de sortie (40), le dispositif (2) étant adapté pour générer un signal de sortie Q représentant au moins la plus grande des valeurs de probabilité d'erreur et la composante de transformateur (16) associée, et le dispositif (2) étant adapté pour transmettre le signal de sortie Q au moyen de l'interface de sortie de signal (36).

4. Dispositif (2) selon la revendication précédente, **caractérisé en ce que** le dispositif (2) est conçu pour générer le signal de sortie Q de telle sorte que le signal de sortie Q représente au moins les deux ou trois plus grandes valeurs de probabilité d'erreur et les composants de transformateur (16) associés.

5. Dispositif (2) selon l'une des revendications précédentes, **caractérisé en ce que** les grandeurs d'état S1, S2 représentées par le signal d'état S sont des grandeurs d'état ternaires qui représentent chacune exactement un état d'état parmi le groupe suivant d'états d'état possibles : État normal N, état anormal A ou état de non-installation.

6. Dispositif (2) selon la revendication précédente, **caractérisé en ce que** l'unité de traitement (6) est configurée pour générer le réseau bayésien (18) sur la base de l'ensemble de données.

7. Dispositif (2) selon l'une des revendications précédentes, **caractérisé en ce que** l'unité de traitement (6) est configurée pour générer les motifs (22) au moyen d'un algorithme de pondération de probabilité (likelihood weighting algorithm).

8. Dispositif (2) selon l'une des revendications précédentes 4 à 7, **caractérisé en ce que** l'unité de traitement (6) est conçue pour générer le signal de sortie Q de telle sorte que le signal de sortie Q représente les valeurs de probabilité d'erreur et les composants de transformateur (16) associés sous la forme d'une première image dans laquelle les valeurs de probabilité d'erreur sont représentées graphiquement et les composants de transformateur (16) sont indexés et/ou désignés.

9. **Système** (28) comprenant :
un dispositif (2) selon l'une des revendications précédentes 4 à 7, et
une unité d'affichage (30) avec un écran,
dans lequel l'interface de sortie de signal (36) du dispositif (2) est couplée à l'unité d'affichage (30) par une première connexion de signal directe ou indirecte pour transmettre le signal de sortie Q à l'unité d'affichage (30), et
dans lequel l'unité d'affichage (30) est adaptée pour afficher sur l'écran une deuxième image indiquant les composants de transformateur (16) et les valeurs de probabilité d'erreur associées, sur la base du signal de sortie Q.

10. Système (28) selon la revendication précédente, **caractérisé en ce que** l'unité d'affichage (30) est conçue de telle sorte que la deuxième image affiche qualitativement les composants de transformateur (16) représentés par le signal de sortie Q sous forme de liste et les valeurs de probabilité d'erreur associées par différentes couleurs et/ou barres.

11. Système (28) selon l'une quelconque des revendications 9 à 10 précédentes, **caractérisé en ce que** le système (28) comporte un système de mesure (10) du transformateur de puissance (12), le système de mesure (10) étant couplé à l'interface d'entrée de signal (4) du dispositif (2) pour transmettre le signal d'état S à l'interface d'entrée de signal (4), le système de mesure (10) comportant plusieurs capteurs (14) configurés chacun pour détecter la caractéristique physique et/ou chimique du transformateur de puissance (12), le transformateur de puissance (12) présentant plusieurs composants de transformateur (16), et chaque capteur (14) étant couplé à au moins l'un des composants de transformateur (16) du transformateur de puissance (12) par une liaison directe ou indirecte respectivement associée, de sorte que la propriété du transformateur de puissance (12) détectée par le capteur (14) respectif est influencée par au moins l'un des composants de transformateur (16).

12. Système (28) selon la revendication précédente, **caractérisé en ce que** le système de mesure (10) est adapté pour détecter par capteur au moins deux des propriétés suivantes du transformateur de puissance (12) : Gaz de chaînes d'hydrocarbures dans le milieu isolant liquide, eau dans le milieu isolant liquide, niveau du milieu isolant liquide, tension électrique, courant électrique, force de serrage de l'enroulement, vitesse de rotation d'un ventilateur, puissance électrique du moteur du ventilateur, volume sonore du ventilateur, couple moteur d'un commutateur à gradins, séquence de commutation du changeur de prises, température du point chaud, température de l'huile supérieure, facteur de perte d'une ou de plusieurs traversées du transformateur de puissance (12), capacité d'une ou de plusieurs traversées du transformateur de puissance (12), signaux acoustiques d'un changeur de prises, intensité vibro-acoustique, et capacité de fonctionnement du déshumidificateur d'air.

13. Système (28) selon l'une quelconque des revendications 9 à 12 précédentes, **caractérisé en ce que** l'unité d'affichage (30) fait partie du système de mesure (10).

14. Système (28) selon l'une quelconque des revendications 9 à 13 précédentes, **caractérisé en ce que** le système (28) comprend un système de surveillance à distance, l'interface de sortie de signal (36) du dispositif (2) étant couplée au système de surveillance à distance par une deuxième liaison de signal, directe ou indirecte, pour transmettre le signal de sortie Q au système de surveillance à distance.

15. Système (28) selon la revendication précédente, **caractérisé en ce que** le système de surveillance à distance est basé sur le cloud.

16. Système (28) selon l'une des revendications précédentes 14 à 15, **caractérisé en ce que** l'unité d'affichage (30) fait partie du système de surveillance à distance.

17. Système (28) selon l'une quelconque des revendications 9 à 16 précédentes, **caractérisé en ce que** le système (28) comprend le transformateur de puissance (12).
